(19) Europäisches Patentamt
European Patent Office
Office européen des brevets

(11) **EP 3 026 721 B1**

(12) **FASCICULE DE BREVET EUROPEEN**

(45) Date de publication et mention
de la délivrance du brevet:
**28.02.2018 Bulletin 2018/09**

(51) Int Cl.:
*H01L 43/08* $^{(2006.01)}$     *G11C 11/16* $^{(2006.01)}$

(21) Numéro de dépôt: **15196561.3**

(22) Date de dépôt: **26.11.2015**

(54) **DISPOSITIF MAGNÉTIQUE À POLARISATION DE SPIN**

MAGNETVORRICHTUNG MIT SPIN-POLARISIERUNG

MAGNETIC DEVICE WITH SPIN POLARISATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.11.2014 FR 1461570**

(43) Date de publication de la demande:
**01.06.2016 Bulletin 2016/22**

(73) Titulaires:
- **COMMISSARIAT À L'ÉNERGIE ATOMIQUE ET AUX ÉNERGIES ALTERNATIVES**
  **75015 Paris (FR)**
- **CENTRE NATIONAL DE LA RECHERCHE SCIENTIFIQUE -CNRS-**
  **75794 Paris Cedex 16 (FR)**
- **Université Joseph Fourier - Grenoble**
  **38041 Grenoble Cedex 9 (FR)**
- **Université Paris-Sud**
  **91405 Orsay Cedex (FR)**

(72) Inventeurs:
- **DIENY, Bernard**
  **38250 LANS EN VERCORS (FR)**
- **SOUSA, Ricardo**
  **38000 GRENOBLE (FR)**
- **LACOSTE, Bertrand**
  **40370 RION DES LANDES (FR)**
- **DEVOLDER, Thibaut**
  **91300 MASSY (FR)**

(74) Mandataire: **Lebkiri, Alexandre**
**Cabinet Camus Lebkiri**
**25, Rue de Maubeuge**
**75009 Paris (FR)**

(56) Documents cités:
**US-A1- 2008 197 431    US-A1- 2012 294 078**

**Description**

La présente invention concerne un dispositif magnétique à polarisation de spin. Elle trouve une application en électronique, notamment dans la réalisation de points mémoire et de mémoire de type MRAM (« Magnetic Random Access Memory ») ou mémoire magnétique à accès aléatoire.

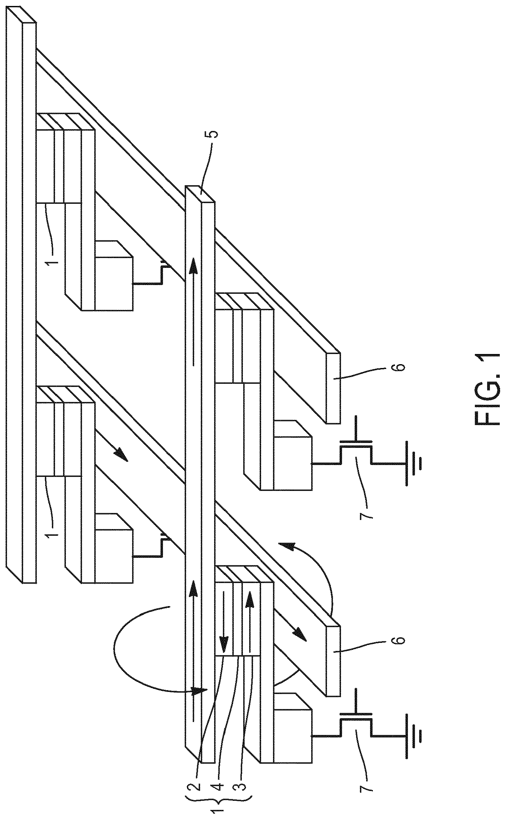

Le contexte est celui des MRAMs à base de jonctions tunnels magnétiques (dits également empilements magnétorésistifs) et plus particulièrement des MRAMs dans lesquelles l'écriture est réalisée par transfert de spin. La figure 1 illustre schématiquement la structure et la fonction d'une telle jonction portant la référence 1. De façon connue, la jonction tunnel magnétique (ou empilement magnétorésistif) 1 est composée de deux couches magnétiques 2 et 3 séparées par une couche d'oxyde 4 formant une barrière tunnel, typiquement en oxyde d'aluminium ou de magnésium. L'aimantation de l'une des couches magnétiques 2, dite couche de stockage (couche d'aimantation ré-orientable suivant deux directions sensiblement opposées) peut être orientée dans différentes directions par rapport à l'aimantation de la seconde couche 3, dite couche de référence, dont l'aimantation est piégée dans une direction fixe. Ce piégeage est en général réalisé par interaction avec une couche antiferromagnétique adjacente non représentée (mécanisme d'anisotropie d'échange). Différents niveaux de résistance de la jonction tunnel peuvent être réalisés en fonction de l'angle entre les aimantations des deux couches de stockage et de référence. Ainsi l'information est stockée dans l'élément magnétique par la configuration magnétique parallèle ou antiparallèle des aimantations des couches de stockage 2 et de référence 3. Ensuite la variation de résistance en fonction de la configuration magnétique est utilisée pour relire l'information écrite dans la cellule mémoire. Lorsque les aimantations des couches magnétiques 2 et 3 sont antiparallèles, la résistance de la jonction 1 est élevée ; lorsque les aimantations sont parallèles, la résistance devient faible. La variation de résistance entre ces deux états peut dépasser 100% par un choix approprié des matériaux. Chaque jonction tunnel 1 constitue un point mémoire.

Dans l'approche la plus classique des MRAMs avec écriture par champs magnétiques perpendiculaires, les jonctions tunnels 1 sont disposées en un réseau carré inséré entre deux réseaux perpendiculaires de lignes parallèles : les lignes de bits 5 (ou « bit lines » en anglais) et les lignes de mots 6 (ou « word lines » en anglais), l'une au dessus, l'autre en dessous du plan des jonctions tunnels 1. Les jonctions 1 sont placées entre un transistor 7 et une ligne de bits 5. Un courant passant dans cette ligne de bits 5 produit un champ magnétique. Un courant passant dans la ligne de mots 6 orthogonale à la ligne de bits 5 permet de produire un second champ magnétique. Au moment de l'écriture, le transistor 7 est bloqué et des impulsions de courant sont envoyées simultanément dans la ligne de mots 6 et la ligne de bits 5 qui se croisent au niveau du point mémoire 1 adressé. La combinaison de ces deux champs permet de faire commuter l'aimantation de la couche de stockage du point mémoire 1 adressé dans la direction souhaitée sans affecter l'aimantation des autres points mémoires. Dans le mode « lecture », le transistor 7 est en régime saturé. Le courant envoyé dans la ligne de bits 5 traverse uniquement le point mémoire dont le transistor est ouvert. Ce courant permet de mesurer la résistance de la jonction. Par comparaison avec un point mémoire de référence, l'état binaire du point mémoire (« 0 » ou « 1 ») peut ainsi être déterminé.

Plus récemment sont apparus d'autres types de dispositifs magnétiques dans lesquels le renversement de l'aimantation se produit non plus par des champs magnétiques extérieurs mais en utilisant l'action exercée par un courant polarisé en spin qui entre dans la couche de stockage de la jonction tunnel. Lorsqu'un courant polarisé en spin est injecté dans une nanostructure magnétique, ce courant exerce un couple sur l'aimantation de la nanostructure, appelé couple de transfert de spin (« spin transfer torque » ou « spin-torque » en anglais), qui peut permettre d'agir sur l'aimantation de la nanostructure et en particulier de la réorienter dans une direction souhaitée. De tels dispositifs magnétiques sont désignés par la terminologie STT-MRAM pour « Spin-transfer torque MRAM »).

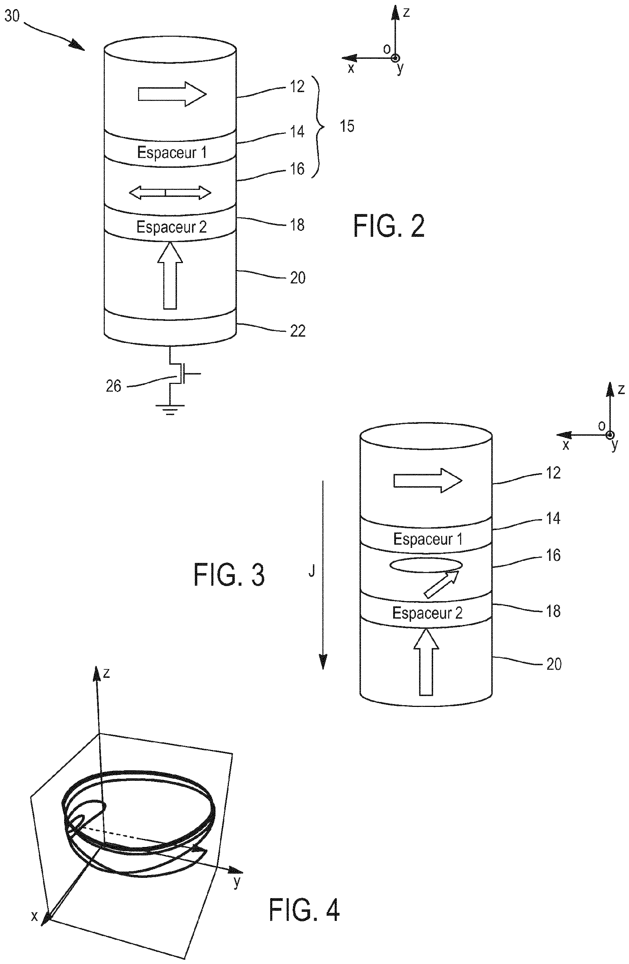

Afin de rendre la commutation des STT-MRAM plus rapide en s'affranchissant des phénomènes de commutation stochastique, une solution proposée dans le brevet FR2817998 consiste, pour provoquer la commutation d'une couche magnétique d'aimantation planaire, à injecter dans cette couche un courant polarisé en spin dont la direction de polarisation est perpendiculaire au plan des couches. Un tel dispositif magnétique 30 (désigné par la terminologie OST-MRAM pour « Orthogonal Spin-transfer MRAM ») est illustré en figure 2. Comme pour le dispositif de la figure 1, le dispositif 30 représenté comprend deux couches magnétiques 12 et 16 séparées par un espaceur 14 formant une barrière tunnel, typiquement en oxyde d'aluminium ou de magnésium. L'aimantation de la couche magnétiques 16 de stockage peut être orientée suivant deux directions sensiblement opposées par rapport à l'aimantation de la couche 12 de référence, dont l'aimantation est piégée dans une direction fixe. La couche de stockage 16 peut être une couche ferromagnétique simple ou une couche antiferromagnétique synthétique constituée de deux couches ferromagnétiques couplées antiparallèlement à travers une fine couche de couplage antiparallèle. Il en va de même pour la couche de référence 16.

L'ensemble 12, 14, 16 constitue une jonction tunnel magnétique 15. Le dispositif 30 se complète par une couche séparatrice non-magnétique conductrice 18 et une couche magnétique de polarisation 20 (désignée également par le terme polariseur perpendiculaire par la suite) ayant une aimantation perpendiculaire au plan de la couche. Le polariseur perpendiculaire 20 peut être une couche ou multicouche simple ou une couche/multicouche synthétique antiferromagnétique comme décrit par exemple dans l'article « Improved coherence of ultrafast spin-transfer-driven precessional switching with synthetic antiferromagnet perpendicular polarizer » (Vaysset et al., Applied Physics Letters 98 (2011) 242511).

La couche de polarisation repose sur une électrode conductrice 22. L'ensemble de cet empilement est inséré entre une amenée de courant non représentée et un transistor 26 de commutation de courant. Pour les électrons transmis (ou réfléchis) à travers la couche 20, la direction du spin se trouvera être orientée parallèlement (ou antiparallèlement) à l'aimantation de cette couche, c'est-à-dire perpendiculairement au plan des diverses couches de la jonction 15 et en particulier au plan de la couche de stockage 16. L'aimantation de cette couche soumise à ce courant d'électrons polarisés hors du plan va tourner suivant un cône de grand angle d'axe Oz perpendiculaire au plan de la couche, sans pouvoir s'aligner avec la direction de spin du fait du champ démagnétisant qui tend à maintenir l'aimantation dans le plan de la couche. On notera que, dans cette situation où la couche de stockage 16 a une aimantation planaire, la jonction possède préférentiellement une forme elliptique assurant une anisotropie de forme dans le plan favorisant un alignement stable de l'aimantation de la couche de stockage suivant le grand axe de l'ellipse.

La figure 3 illustre symboliquement cette rotation. Dans ce dispositif, le transfert de spin généré par le courant polarisé par le polariseur perpendiculaire 20 induit un mouvement de précession de grand angle de l'aimantation de la couche de stockage 16. Ce mouvement de précession vient du fait que l'aimantation de la couche de stockage 16 tend à légèrement sortir hors du plan sous l'effet du transfert de spin provenant du polariseur perpendiculaire 20 et à tourner alors dans le champ démagnétisant orienté hors du plan subit par cette couche de stockage 16. Si le courant est continu, l'aimantation de la couche douce n'arrête pas de tourner ce qui peut générer une oscillation entretenue de la résistance de l'élément magnétorésistif. Ce phénomène est intéressant en soi et permet d'envisager la réalisation d'oscillateurs RF accordables en fréquence comme démontré par exemple dans la publication « Spintorque oscillator using a perpendicular polarizer and a planar free layer » (D. Houssameddine et al., Nature Materials 6, 447 (2007)).

Sous l'effet du transfert de spin exercé par le polariseur perpendiculaire 20 sur la couche de stockage 16, l'aimantation décrit une trajectoire quasi-circulaire dans un plan parallèle au plan de la couche de stockage comme illustré sur la figure 4 qui montre cette rotation. Un trièdre trirectangle Oxyz (représenté sur les figures 3 et 4) permet de repérer les différentes directions, l'axe Oz étant perpendiculaire au plan des couches.

Toutefois, pour une application mémoire, on ne cherche pas à générer un mouvement entretenu d'aimantation dans une couche de stockage mais à faire commuter l'aimantation de la couche de stockage entre deux positions stables d'aimantation correspondant à deux niveaux de résistance électrique différents.

En contrôlant la durée du mouvement de précession généré par le polariseur perpendiculaire à une demi-période près, il est possible d'utiliser le mouvement de précession pour faire commuter l'aimantation de la couche 16 d'aimantation planaire entre deux directions opposées. L'avantage de cette approche est que la commutation est en principe très rapide (de l'ordre de 0.3ns) et peu sensible aux fluctuations stochastiques. En effet, les fréquences de précession dans ces dispositifs sont typiquement dans la gamme de 3GHz à 10GHz ce qui correspond à des périodes de rotation d'aimantation de 300 à100 ps et donc à des temps de commutation de l'état de la cellule mémoire de 150 à 50ps (le temps pour faire un demi-tour étant moitié du temps pour faire un tour complet). Un autre avantage de cette approche est le fait que les pulses de courant d'écriture peuvent être tous de même polarité. Chaque pulse déclenchera une rotation dans le sens trigonométrique direct (ou inverse si la polarité des pulses est inversée) mais l'aimantation peut être commutée par saut de 180°) en tournant toujours dans le même sens.

Des dispositfs connus sont décrits par US 2008 / 0197431 A1 et US 2012 / 0294078 A1.

Toutefois, une telle configuration présente au moins deux inconvénients.

Tout d'abord, elle oblige à lire l'état magnétique de la couche de stockage avant d'écrire. En effet, si l'état final que l'on veut écrire correspond à l'état initial, on ne doit pas envoyer de pulse de courant. Il suffit de laisser la mémoire dans son état actuel. Par contre, si la lecture révèle que la mémoire n'est pas dans l'état que l'on veut écrire, on doit alors envoyer un pulse de courant pour la faire commuter dans l'état opposé. Le problème est que cette étape de lecture précédent l'écriture peut prendre quelques nanosecondes donc même si la commutation magnétique est ensuite rapide, le fait de devoir lire avant d'écrire allonge le cycle d'écriture de plusieurs nanosecondes ce qui rend cette approche inutilisable pour les applications nécessitant des durées d'écriture de l'ordre de la sub-nanoseconde.

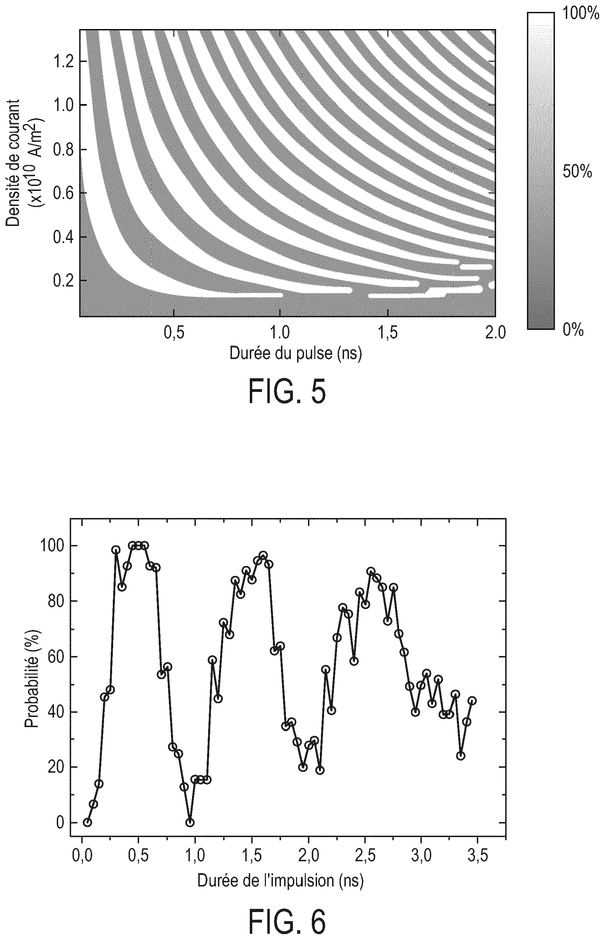

Un second inconvénient réside dans la nécessité de devoir contrôler la durée des pulses à l'échelle de 50ps pour être sûr de faire faire une demi-précession à l'aimantation de la couche de stockage. Le mouvement de précession conduit à une probabilité oscillante en fonction de la durée des pulses entre 0% et 100% d'arriver dans l'état opposé à l'état de départ (c'est-à-dire finir dans l'état parallèle en partant de l'état antiparallèle et réciproquement de finir dans l'état antiparallèle en partant de l'état parallèle). La fréquence de précession augmente avec l'intensité du courant traversant le dispositif. Ceci conduit à une variation de la probabilité de commutation oscillant en fonction de la durée des pulses de courant à amplitude de la densité de courant constante ou en fonction de la densité de courant à durée constante comme illustré sur la figure 5. On peut faire commuter l'aimantation de la couche de stockage en lui faisant faire 1/2 tour mais on pourrait en principe le faire en faisant 3/2 tours, 5/2 tours.... Mais dans tous les cas, il faut contrôler la durée du pulse de courant à mieux que ±1/4 de période près soit de l'ordre de 50ps. Ceci est faisable à l'échelle d'un point mémoire individuel mais beaucoup plus difficile à l'échelle d'une puce mémoire entière comportant des millions de points mémoires. En effet, à cause des résistances des lignes de courant qui interconnectent tous les points mémoires (les lignes de bits ou « bit lines » et les lignes de mots ou « word lines » évoquées plus haut), de leurs capacités et inductance parasites, un pulse de courant se propageant le long des lignes d'interconnections a tendance à s'atténuer et à se déformer. Le pulse n'a donc pas le même profil au niveau du premier point mémoire et du dernier le long d'une même ligne ou colonne de points mémoires ce qui rend très difficile ce contrôle précis de la durée des pulses. La figure 6 montre la probabilité de commutation de la couche de stockage en fonction de la durée du pulse confirmant le diagramme de la figure 5.

Dans ce contexte, la présente invention a pour but de fournir un dispositif magnétique à écriture via la précession de l'aimantation par transfert de spin permettant de s'affranchir des exigences précitées sur le contrôle trop précis de la durée d'impulsion de courant (c'est-à-dire une durée inférieure à 300 ps contrôlée à ±50 ps près) traversant le dispositif et permettant de réaliser une écriture ne nécessitant pas une lecture du dispositif avant l'écriture.

A cette fin, l'invention propose un dispositif magnétique comportant :

- une première couche magnétique, dite couche de stockage, présentant une anisotropie uni-axiale avec un axe facile d'aimantation dans le plan de ladite couche de stockage et ayant une aimantation de direction variable possédant deux positions d'équilibre suivant ledit axe facile d'aimantation ;
- une deuxième couche magnétique, dite couche de polarisation de spin d'électrons, ayant une aimantation perpendiculaire à celle de ladite couche de stockage et située hors du plan de la couche de polarisation de spin d'électrons ;
- des moyens pour faire circuler dans les couches, et perpendiculairement à celles-ci, un courant pour commuter d'une position d'équilibre de la direction d'aimantation de la couche de stockage à l'autre;

ledit dispositif comportant des moyens pour appliquer un champ magnétique dont la direction est sensiblement parallèle au plan de ladite couche de stockage et sensiblement perpendiculaire à l'axe facile d'aimantation de la couche de stockage.

On entend par couche de stockage présentant une forte anisotropie uni-axiale avec un axe de facile aimantation, une couche de stockage réalisée dans un matériau ferromagnétique pour lequel il existe une anisotropie magnéto-cristalline due aux interactions entre le moment magnétique et le réseau cristallin. Il en résulte une direction dite de facile aimantation dans laquelle l'aimantation va s'aligner naturellement en l'absence de sollicitation extérieure. A cette anisotropie cristalline, une anisotropie de forme va pouvoir s'ajouter, dépendant cette fois ci de la forme de la jonction : par exemple, si l'on utilise une couche de stockage (et donc une jonction) de forme allongée (par exemple ovale ou elliptique), l'anisotropie de forme va tendre à aligner l'aimantation suivant l'axe le plus grand de la jonction. Si l'axe de facile aimantation magnéto-cristalline est orienté suivant cette même direction, les effets vont s'additionner et on va obtenir une stabilité importante de la couche de stockage.

L'invention repose sur le principe d'appliquer, au moins pendant la durée de l'écriture (c'est-à-dire pendant la durée où l'on veut donner à l'aimantation de la couche de stockage l'une ou l'autre de ses positions d'équilibre) un champ transverse à la direction de facile aimantation de la couche de stockage, ce champ étant appliqué sensiblement dans le plan de la couche. Ce champ transverse doit être appliqué dans le bon sens suivant la direction du pulse de courant d'écriture pour favoriser la rotation initiale de l'aimantation pendant la partie de la précession entre l'état de départ et le moment où la composante planaire de l'aimantation est suivant la direction transverse et défavoriser ensuite la précession de l'aimantation entre cette position transverse et la position transverse de sens opposé. Ce champ transverse aide à initier le mouvement de précession de l'aimantation pendant le premier quart d'une rotation de l'aimantation de la couche de stockage mais gêne ensuite le mouvement de précession pendant la demie période suivante en forçant l'aimantation de la couche stockage à rester dans l'hémisphère de ce champ transverse.

En d'autres termes, grâce à l'application de ce champ transverse, on aide l'aimantation de la couche de stockage à démarrer son mouvement de commutation sous l'effet du transfert de spin dû au polariseur perpendiculaire, tout en la retenant dans l'hémisphère du champ transverse ce qui l'empêche de partir dans un mouvement de rotation continue comme lorsque le champ transverse n'est pas appliqué.

On notera que le champ transverse doit être présent pendant l'écriture mais qu'il ne doit pas nécessairement être présent en dehors de l'écriture. Il peut même être préférable dans certains cas qu'il ne soit pas présent hors écriture car il est susceptible de nuire à la stabilité thermique de l'aimantation de la couche de stockage en réduisant la hauteur de barrière séparant l'état parallèle (P) de l'état antiparallèle (AP). Cependant, du point de vue pratique, il est plus aisé d'appliquer ce champ en permanence sur le dispositif. Dans ce cas, comme nous le verrons par la suite, le champ peut être créé par une couche d'aimantation fixe en matériau dur ou piégé par anisotropie d'échange. Pour appliquer un champ uniquement pendant l'écriture, une solution peut consister à rajouter une ligne conductrice supplémentaire au-dessus ou en-dessous des points mémoires comme dans le cas des dispositifs MRAM à écriture par champ. La conséquence directe est une augmentation de la consommation électrique associée à la génération de ce champ par pulse de courant pendant l'écriture. Dans une optique de diminution de la consommation électrique, l'application d'un champ transverse permanent est donc a priori préférable.

Le dispositif magnétique selon l'invention peut également présenter une ou plusieurs des caractéristiques ci-dessous, considérées individuellement ou selon toutes les combinaisons techniquement possibles :

- lesdits moyens pour faire circuler un courant et lesdits moyens pour appliquer un champ magnétique transverse sont configurés de sorte que le produit scalaire $\left(\vec{J} \times \vec{M}_{initiale}\right).\vec{H}_y$, le signe « x » désignant le produit vectoriel, soit du même signe que la composante de l'aimantation de la couche de polarisation suivant un axe allant de la couche de polarisation vers la couche de stockage, où $\vec{M}_{initiale}$ représente le vecteur d'aimantation initiale dans l'une des deux positions d'équilibre de la couche de stockage, $\vec{J}$ représente le vecteur de densité courant pour faire commuter l'aimantation de la couche de stockage de l'état initial $\vec{M}_{initiale}$ correspondant à la position d'équilibre avant commutation vers l'état final correspondant au deuxième état d'équilibre après commutation et $\vec{H}_y$ représente le vecteur du champ transverse ;

- le dispositif selon l'invention comporte :

  ◦ une troisième couche magnétique, dite couche de référence, ayant une aimantation de direction fixe située dans le plan de la couche de référence sensiblement selon ledit axe facile d'aimantation ;
  ◦ une couche non magnétique, dite premier espaceur, séparant ladite couche de référence et ladite couche de stockage ;

- au moins l'une desdites couches de référence, de stockage ou de polarisation de spin d'électrons est une couche antiferromagnétique synthétique formée de deux couches d'aimantation fixe et couplées antiparallèlement par une couche apte à induire un couplage antiferromagnétique entre les couches ferromagnétiques ;
- au moins l'une desdites couches de référence ou de polarisation de spin d'électrons présente une aimantation piégée par interaction avec une couche antiferromagnétique de piégeage ;
- ladite couche de référence et ladite couche de polarisation de spin sont choisies de sorte que le produit scalaire $\left(\vec{M}_{analyseurplanaire} \times \vec{P}\right).\vec{H}_y$ soit strictement positif, où $\vec{M}_{analyseurplanaire}$ est le vecteur d'aimantation de direction fixe de la couche de référence et $\vec{P}$ est le vecteur d'aimantation de la couche de polarisation de spin ;
- le dispositif selon l'invention comporte une couche, dite second espaceur, séparant ladite couche de stockage et ladite couche de polarisation de spin d'électrons ;
- le produit de la résistance par la surface dudit premier espaceur est supérieur au produit de la résistance par la surface dudit second espaceur ;
- ledit premier espaceur est une barrière tunnel et ledit second espaceur est choisi parmi les éléments suivants :

  ◦ une barrière tunnel ;
  ◦ une barrière à chemins de courant confinés ;
  ◦ une couche métallique non magnétique ;

- lesdits moyens pour appliquer ledit champ transverse sont formés par une couche de matériau ferromagnétique ;
- lesdits moyens pour appliquer ledit champ transverse sont formés par une couche de matériau ferromagnétique dont l'aimantation est piégée par une couche antiferromagnétique ;
- lesdits moyens pour appliquer ledit champ transverse sont formés par une ligne conductrice de génération de champ dans laquelle circule un courant ;
- lesdits moyens pour appliquer ledit champ transverse sont formés par deux aimants permanents situés de part et d'autre de l'empilement magnétique. ;
- lesdits moyens pour appliquer ledit champ transverse sont formés par un aimant permanent situé au-dessus ou au-dessous de l'empilement magnétique.

D'autres caractéristiques et avantages de l'invention ressortiront clairement de la description qui en est donnée ci-dessous, à titre indicatif et nullement limitatif, en référence aux figures annexées, parmi lesquelles :

- la figure 1 représente schématiquement un ensemble de jonctions tunnel magnétiques dans un dispositif mémoire illustrant la structure et la fonction d'une jonction tunnel magnétique ;
- la figure 2 illustre un dispositif magnétique selon l'état de la technique ;
- la figure 3 montre la rotation de l'aimantation de la couche de stockage dans le dispositif de la figure 2 ;

- la figures 4 montre la trajectoire circulaire de l'aimantation dans un plan parallèle au plan de la couche de stockage du dispositif de la figure 2 ;
- la figure 5 représente la variation de la probabilité de commutation de l'aimantation de la couche de stockage du dispositif de la figure 2 oscillant en fonction de la durée des pulses de courant à amplitude de la densité de courant constante ou en fonction de la densité de courant à durée constante ;
- la figure 6 montre la probabilité de commutation de l'aimantation de la couche de stockage du dispositif de la figure 2 en fonction de la durée du pulse ;
- la figure 7 représente de manière schématique un dispositif magnétique selon l'invention ;
- les figures 8 et 9 illustrent de manière schématiques le fonctionnement en écriture du dispositif de la figure 7 ;
- la figure 10 représente de manière schématique un dispositif magnétique selon l'invention appliqué au cas d'un dispositif MRAM ;
- les figures 11 a et 11b représentent respectivement la dynamique de l'aimantation des couches de stockage du dispositif de la figure 2 et du dispositif selon l'invention de la figure 10 ;
- les figures 12a à 12c illustrent comment l'amplitude de la densité de courant d'écriture doit être choisie pour une valeur donnée du champ transverse pour commuter de l'état antiparallèle à l'état parallèle ou de l'état à l'état avec ou sans probabilité oscillante ;
- les figures 13 et 14 représentent des diagrammes de stabilité de l'aimantation de la couche de stockage d'un dispositif selon l'invention sous l'influence du transfert de spin du polariseur perpendiculaire en présence d'un champ magnétique transverse respectivement avec un état initial parallèle et antiparallèle ;
- les figures 15 à 17 représentent des exemples de variations temporelles des composantes de l'aimantation de la couche de stockage d'un dispositif selon l'invention sous l'effet d'un champ transverse avec différentes valeurs de densités de courant traversant la jonction tunnel ;
- les figures 18 à 20 illustrent trois exemples d'empilement magnétique utilisable pour le dispositif selon l'invention ;
- La figure 21 illustre un premier mode de réalisation des moyens pour appliquer un champ transverse, uniquement pendant l'écriture ;
- Les figures 22a et 22b illustrent la déviation de l'aimantation de la couche de stockage par rapport à l'axe facile d'aimantation liée à l'application du champ transverse dans un dispositif selon l'invention ;
- les figures 23 à 26 illustrent quatre modes de réalisation de moyens pour appliquer un champ transverse permanent dans le dispositif selon l'invention.

Les figures 1 à 6 ont déjà été décrites en référence à l'état de la technique.

Un trièdre trirectangle Oxyz permet de repérer les différentes directions, l'axe Oz étant perpendiculaire au plan des couches.

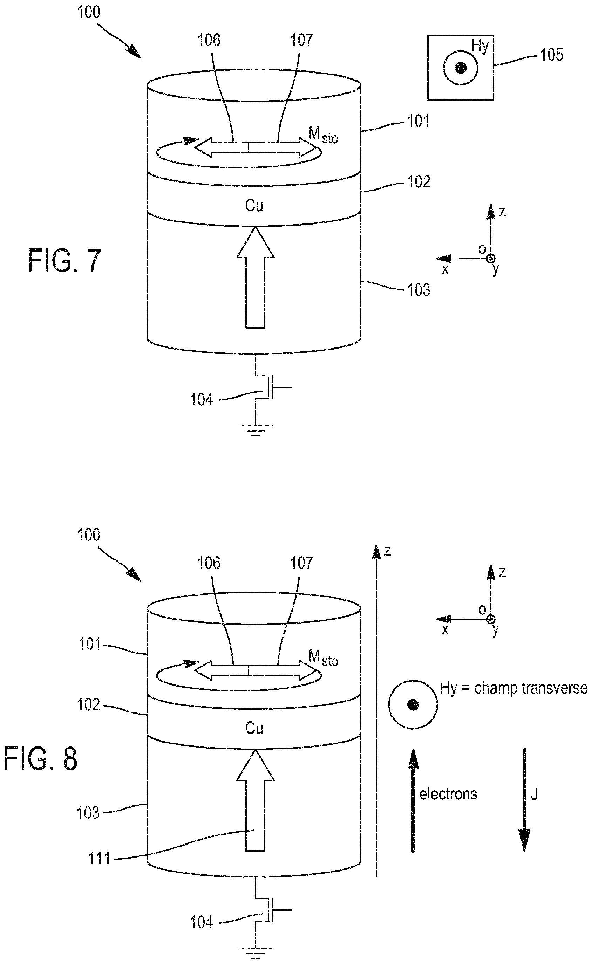

La figure 7 représente schématiquement un dispositif magnétique 100 selon l'invention.

Le dispositif magnétique 100 comporte :

- une couche magnétique de stockage 101 présentant une anisotropie uniaxiale avec un axe facile d'aimantation (en l'espèce l'axe Ox) dans le plan de ladite couche de stockage ; la couche de stockage 101a une aimantation de direction variable possédant deux positions d'équilibre suivant ledit axe Ox ;
- un espaceur 102 ;
- une couche 103 de polarisation de spin d'électrons (désigné également par la terminologie polariseur perpendiculaire), ayant une aimantation hors du plan de la couche de polarisation et de direction perpendiculaire à l'axe facile d'aimantation.

Comme évoqué plus haut, le vecteur d'aimantation $\vec{M}_{STO}$ de la couche de stockage 101 possède deux positions d'équilibre 107 et 106 (indifféremment désignées par la terminologie premier état stable et deuxième état stable par la suite) dirigées respectivement sensiblement suivant le sens de l'axe Ox et suivant le sens opposé à l'axe Ox.

La couche de stockage 101 présente préférentiellement une forme allongée (par exemple elliptique) de façon à renforcer l'anisotropie uniaxiale pour donner à l'aimantation de la couche de stockage une anisotropie de forme dans le plan permettant à l'aimantation d'avoir une certaine stabilité.

Cet empilement formé par l'ensemble de couches ci-dessus est inséré entre une amenée de courant non représenté et un moyen de commutation de courant 104 qui est ici un transistor permettant de faire circuler un courant électrique perpendiculairement au plan de l'empilement de couches magnétiques.

Le dispositif 100 selon l'invention comporte en outre des moyens 105 pour appliquer un champ magnétique Hy, dit champ transverse, dont la direction est sensiblement parallèle au plan de la couche de stockage 101 et sensiblement perpendiculaire à l'axe facile d'aimantation Ox. En d'autres termes, le champ transverse Hy est ici dirigé sensiblement suivant l'axe Oy.

Les moyens 105 d'application du champ transverse sont configurés pour permettre l'application du champ transverse au moins pendant la phase d'écriture, c'est-à-dire pendant la phase permettant de passer d'une position d'équilibre de la direction d'aimantation (respectivement 106 ou 107) de la couche de stockage 101 à l'autre (respectivement 107 ou 106).

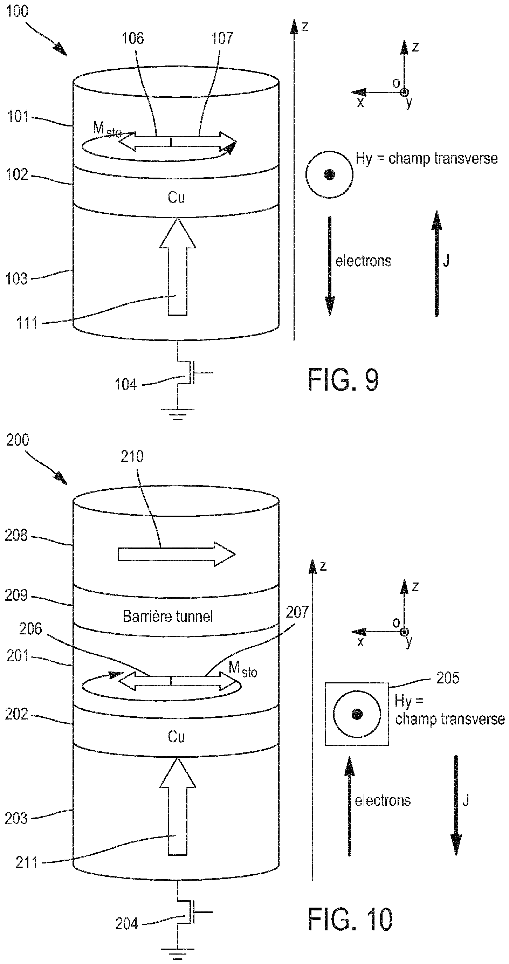

L'illustration du fonctionnement en écriture du dispositif 100 de la figure 7 va être faite en référence aux figures 8 et 9.

Sur la figure 8, partant d'un premier état stable 107 c'est-à-dire dans lequel l'aimantation de la couche de stockage 101 est sensiblement suivant le sens opposé à l'axe Ox, on peut écrire le deuxième état stable 106 (i.e. faire commuter l'aimantation de la couche de stockage 101 du premier état stable 107 vers le deuxième état stable 106) en envoyant un pulse d'électrons du polariseur perpendiculaire 103 vers la couche de stockage 101 (c'est-à-dire un pulse de courant de la couche de stockage 101 vers le polariseur 103), le vecteur de champ transverse $\vec{H}_y$ pointant suivant le sens de l'axe Oy comme indiqué sur la figure 8 dans le même hémisphère que le produit vectoriel $\vec{J} \times \vec{M}_{initiale}$, le signe « x » désignant le produit vectoriel, où $\vec{M}_{initiale}$ représente le vecteur d'aimantation initiale dans la position d'équilibre 107 de la couche de stockage 101 et $\vec{J}$ représente le vecteur de densité courant pour passer de la position d'équilibre 107 à la position d'équilibre 106 et circulant de la couche de stockage 101 vers le polariseur perpendiculaire 103.

A l'inverse, comme illustré sur la figure 9, partant de l'état d'équilibre 106, on peut arriver à l'état d'équilibre 107 en gardant le même champ transverse que précédemment (i.e. figure 8) et en renversant la direction du courant d'écriture.

Ainsi, grâce à l'application de ce champ transverse convenablement choisi, on bénéficie toujours d'une commutation très rapide (sub-nanoseconde) mais l'état final est ici contrôlé par la direction du courant traversant l'empilement indépendamment de la durée du pulse de courant d'écriture. On lève la double contrainte de devoir lire avant d'écrire et de devoir contrôler la durée du pulse avec une précision de $\pm 50$ps.

Le dispositif selon l'invention trouve une application particulièrement intéressante lorsqu'il est utilisé en tant que dispositif mémoire de type MRAM (« Magnectic Random Access Memory ») ou mémoire magnétique à accès aléatoire. Un tel dispositif 200 est illustré en figure 10.

Le dispositif magnétique 200 comporte :

- une couche magnétique de référence 208 de direction d'aimantation 210 fixe (ici suivant le sens opposé à l'axe Ox) ;
- un espaceur non magnétique 209 ;
- une couche magnétique de stockage 201 présentant une anisotropie uniaxiale avec un axe facile d'aimantation (en l'espèce l'axe Ox) dans le plan de ladite couche de stockage ; la couche de stockage 201 a une aimantation de direction variable possédant deux positions d'équilibre suivant ledit axe Ox ;
- un espaceur 202 ;
- une couche 203 de polarisation de spin d'électrons (désigné également par la terminologie polariseur perpendiculaire), ayant une aimantation 211 hors du plan de la couche de polarisation et de direction perpendiculaire à l'axe facile d'aimantation.

Cet empilement formé par l'ensemble de couches ci-dessus est inséré entre une amenée de courant non représenté et un moyen de commutation de courant 204 qui est ici un transistor permettant de faire circuler un courant électrique perpendiculairement au plan de l'empilement de couches magnétiques.

L'espaceur 209 forme une barrière tunnel et sépare la couche de référence 208 de la couche de stockage 201 tandis que l'espaceur 202 sépare le polariseur perpendiculaire 203 de la couche de stockage 201.

Le vecteur d'aimantation $\vec{M}_{STO}$ de la couche de stockage 201 possède deux positions d'équilibre 207 et 206 (indifféremment désignées par la terminologie premier état stable et deuxième état stable par la suite) dirigées respectivement sensiblement suivant le sens de l'axe Ox et suivant le sens opposé à l'axe Ox. L'empilement possède donc deux états magnétiques stables :

- un premier état dit état parallèle P dans lequel l'aimantation 210 de la couche de référence 208 est parallèle à l'aimantation de la couche de stockage 201 (position d'équilibre 207) ;
- un deuxième état dit état antiparallèle dans lequel l'aimantation 210 de la couche de référence 208 est dans le sens opposé à l'aimantation de la couche de stockage 201 (position d'équilibre 206).

L'empilement possède des propriétés magnétorésistives c'est-à-dire qu'il est tel que les deux états magnétiques stables sont caractérisés par deux valeurs différentes de résistance électrique de la structure. L'empilement peut être un empilement magnétorésistif, ou une structure métallique ou à chemin de courants confinés à magnétorésistance géante, ou une structure dite filtre à spin comprenant une barrière d'oxyde magnétique. La commutation d'un état magnétique à l'autre se produit par transfert de spin, c'est-à-dire à l'aide d'un courant polarisé en spin traversant la couche de stockage 201.

L'espaceur 202 présente une résistance inférieure à celle de l'élément magnétorésistif formé par la couche de référence 208 et la couche de stockage 201 séparées par l'espaceur non magnétique 209. La résistance électrique de l'espaceur 202 doit en effet être suffisamment faible par rapport à celle de l'élément magnétorésistif de sorte que l'effet de magnétorésistance du dispositif 200 ne soit pas trop réduit en valeur relative par la résistance en série de l'espaceur 202. Le second espaceur 202 est en contact avec la couche de stockage 201 du côté opposé de l'élément magnétorésistif.

La couche 203 de polarisation de spin d'électrons est en contact avec l'espaceur 202.

La couche de stockage 201 présente une anisotropie uniaxiale pouvant être renforcée en donnant à la structure une forme allongée elliptique pour donner à l'aimantation de la couche de stockage une anisotropie de forme dans le plan permettant à l'aimantation d'avoir une certaine stabilité et donc à la mémoire d'avoir une certaine rétention. Cette anisotropie uniaxiale confère à l'aimantation de la couche de stockage 201 les deux états stables d'aimantation sensiblement parallèle et antiparallèle à l'aimantation de la couche de référence 209.

Comme dans le cas du dispositif 100 de la figure 7, le dispositif 200 comporte en outre des moyens 205 pour appliquer un champ magnétique Hy, dit champ transverse, dont la direction est sensiblement parallèle au plan de la couche de stockage 201 et sensiblement perpendiculaire à l'axe facile d'aimantation Ox. En d'autres termes, le champ transverse Hy est ici dirigé sensiblement suivant l'axe Oy.

Les moyens 205 d'application du champ transverse sont configurés pour permettre l'application du champ transverse au moins pendant la phase d'écriture, c'est-à-dire pendant la phase permettant de passer d'une position d'équilibre de la direction d'aimantation (respectivement AP ou P) de la couche de stockage 201 à l'autre (respectivement P ou AP).

Comme illustré sur la figure 10, partant de l'état parallèle P (configuration d'équilibre 207) c'est-à-dire dans lequel l'aimantation de la couche de stockage 201 est sensiblement parallèle à l'aimantation 210 de la couche de référence 208 (désigné indifféremment par le terme analyseur planaire) d'aimantation planaire, on peut écrire l'état AP (antiparallèle) en envoyant un pulse d'électrons du polariseur perpendiculaire 203 vers la couche de stockage 201 (c'est-à-dire un pulse de courant de la couche de stockage 201 vers la couche de référence 208), le vecteur de champ transverse $\vec{H}_y$ pointant suivant le sens de l'axe Oy comme indiqué sur la figure 10 dans le même hémisphère que le produit vectoriel $\vec{J} \times \vec{M}_{initiale}$, le signe « x » désignant le produit vectoriel, où $\vec{M}_{initiale}$ représente le vecteur d'aimantation initiale dans l'état magnétique P et $\vec{J}$ représente le vecteur de densité courant pour passer de l'état P vers l'état AP circulant de la couche de stockage 201 vers le polariseur perpendiculaire 203.

A l'inverse, partant de l'état antiparallèle AP, on peut arriver à l'état P en gardant le même champ transverse que précédemment et en renversant la direction du courant d'écriture.

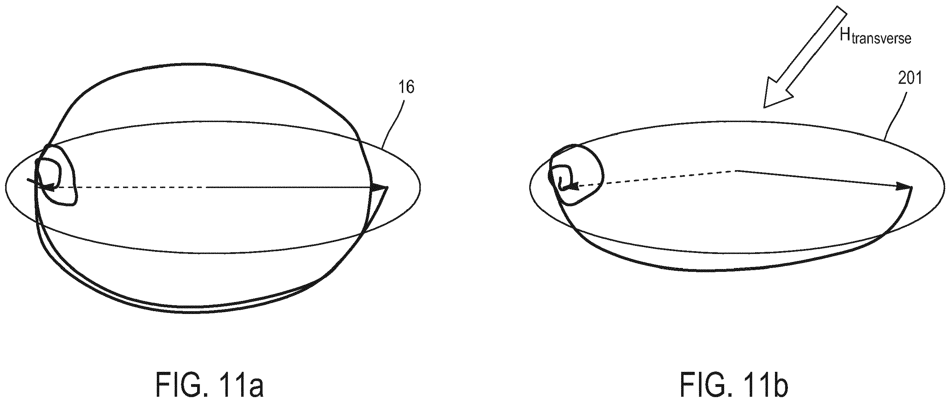

L'influence du champ transverse est illustrée sur les figures 11a et 11b qui représentent respectivement la dynamique de l'aimantation des couches de stockage 16 et 201 de forme elliptique du dispositif 30 de l'état de la technique et du dispositif 200 selon l'invention. Les ellipses représentent les couches de stockage 16 et 201 en vue de dessus. La figure 11 a illustre la dynamique d'aimantation sous l'effet du transfert de spin dû au polariseur perpendiculaire en l'absence de champ transverse. Aussi longtemps que le courant circule, l'aimantation de la couche de stockage tourne sur une trajectoire circulaire comme représenté aussi sur les figures 3 et 4. En présence du champ transverse (figure 11 b), l'aimantation est empêchée d'aller dans l'hémisphère opposée au champ transverse. Elle est retenue par le champ transverse dans son hémisphère. Du coup, même si la durée du pulse de courant dépasse une demie précession, l'aimantation sera empêchée d'effectuer un mouvement de précession continu. De ce fait, lorsque le courant est arrêté, l'aimantation de la couche de stockage relaxe dans la direction opposée à l'état de départ.

De façon connue, lorsqu'un courant circule à travers un empilement tel que celui du dispositif 200, l'aimantation de la couche de stockage 201 se trouve soumise à l'influence de deux contributions au transfert de spin :

- La contribution due au polariseur perpendiculaire 203 qui tend à générer un mouvement de précession de l'aimantation de la couche de stockage 201.
- La contribution due à la couche de référence 208 qui comme dans les jonctions tunnels magnétiques planaires conventionnelles génère une commutation dont l'état final est contrôlé par la direction du courant (état parallèle P favorisé si les électrons vont de la couche de référence 208 vers la couche de stockage 201 et état antiparallèle AP favorisé lorsque les électrons vont de la couche de stockage 201 vers la couche de référence 208).

La dynamique d'aimantation de la couche de stockage $\vec{M}_{sto}$ est décrite par l'équation de Landau Lifshitz Gilbert en présence des deux contributions de transfert de spin précédemment décrites :

$$\frac{d\vec{M}_{sto}}{dt} = -\gamma_0\,\vec{M}_{sto}\times\vec{H}_{eff} + \frac{\alpha}{M_S}\vec{M}_{sto}\times\frac{d\vec{M}_{sto}}{dt} + a_{JLong}\,\vec{M}_{sto}\times(\vec{M}_{ref}\times\vec{M}_{sto}) + a_{jPerp}\,\vec{M}_{sto}\times(\vec{P}\times\vec{M}_{sto})$$

où $\vec{M}_{STO}$ désigne le vecteur aimantation de la couche de stockage, $H_{eff}$ désigne le champ effectif, $-\gamma_0$ désigne le facteur de champ gyromagnétique, $\alpha$ désigne le coefficient d'amortissement de Gilbert, $M_S$ désigne l'aimantation spontanée de la couche de stockage, $\vec{P}$ désigne l'aimantation du polariseur perpendiculaire, $a_{JLong}$ et $a_{JPerp}$ sont respectivement les pré-facteurs des couples de transfert de spin associés à la couche de référence et au polariseur perpendiculaire.

Le mouvement de précession déclenché par le pulse de courant va être contrôlé par le premier terme qui est le terme précessionnel. Le rôle du transfert de spin est essentiellement de contrebalancer la dissipation décrite par le terme d'amortissement de Gilbert qui est le deuxième terme du membre de droite de l'équation ci-dessus. L'importance de la direction du champ transverse peut ainsi être comprise en se focalisant sur le premier terme :

$$\frac{d\vec{M}_{sto}}{dt} = -\gamma_0\,\vec{M}_{sto}\times\vec{H}_{eff}\,.$$

Le champ effectif $H_{eff}$ agissant sur l'aimantation est ici dominé par le terme de champ démagnétisant. Considérons la situation de la figure 8 sur laquelle l'état initial correspondant à $\vec{M}_{sto}$ est orienté dans un premier état stable 107. Sur la figure 8, on suppose par exemple que l'aimantation de la couche de stockage dans ce premier état stable est initialement orientée vers la droite (état 107). Lorsqu'un pulse de courant est envoyé de la couche de stockage 101 vers le polariseur perpendiculaire 103, c'est-à-dire les électrons allant du polariseur perpendiculaire 103 vers la couche de stockage 101, l'aimantation de la couche de stockage 101 a tendance à sortir du plan. Si l'aimantation du polariseur perpendiculaire 103 est vers le haut comme sur la figure 8, l'aimantation de la couche de stockage 101 pour cette direction de courant aura tendance à être tirée dans l'hémisphère du haut de sorte qu'un champ démagnétisant hors du plan vers le bas va apparaitre et agir sur l'aimantation de la couche de stockage 101. Ce champ démagnétisant vers le bas va constituer le terme dominant du champ effectif $H_{eff}$, les autres termes étant un éventuel champ appliqué (en particulier le champ rayonné par les autres couches) et le champ d'anisotropie planaire. Sous l'effet du champ effectif

$$\frac{d\vec{M}_{sto}}{dt} = -\gamma_0\,\vec{M}_{sto}\times\vec{H}_{eff}\,,$$

vertical vers le bas et suivant l'équation l'aimantation va tourner dans le sens des aiguilles d'une montre (clockwise) comme indiqué sur la figure 8. Le champ transverse doit alors être choisi dans la direction sensiblement transverse (orthogonale) à la direction de facile aimantation (Ox) de la couche de stockage 101 correspondant à la direction d'aimantation de la couche de stockage après ¼ de période de précession sous l'effet du transfert de spin dû au polariseur perpendiculaire 103 (c'est-à-dire selon l'axe Oy sur la figure 8).

De même, partant de l'état opposé du point mémoire (qui peut être également un memristor ou un dispositif logique du type MLU « Magnetic Logic Unit) c'est-à-dire celui où l'aimantation de la couche de stockage 101 est orientée suivant le second état stable (état 106 vers la gauche sur la figure 9), en envoyant un pulse de courant du polariseur perpendiculaire 103 vers la couche de stockage 101 c'est-à-dire un pulse d'électrons allant de la couche de stockage 101 vers le polariseur perpendiculaire 103, l'aimantation de la couche de stockage 101 va être tirée hors du plan vers le bas sous l'effet du transfert de spin dû au polariseur perpendiculaire 103 ce qui va entrainer un début de mouvement de précession de l'aimantation dans le sens inverse des aiguilles d'un montre comme indiqué sur la figure 9. En gardant la même direction et le même sens de champ transverse Hy que dans le cas précédent (c'est-à-dire un champ transverse appliqué selon Oy), ce mouvement de précession va être aidé par le champ transverse Hy pendant le premier ¼ de la rotation d'aimantation et freiné ensuite. Ceci va permettre de stopper le mouvement de précession de grand angle une fois que l'aimantation aura commuté dans l'hémisphère de droite.

On voit donc que, en gardant le champ transverse toujours orienté dans le même sens, on peut faire commuter l'aimantation de la couche de stockage très rapidement (à l'échelle sub-nanoseconde) d'une première position d'équilibre vers une deuxième position d'équilibre et réciproquement sans avoir à contrôler précisément la durée du pulse de courant. On résout ainsi les deux problèmes rencontrés dans l'état de l'art.

Concernant le choix de la direction et du sens du champ transverse par rapport au sens des pulses de courant permettant l'écriture du premier ou second état stable, le champ transverse doit être sensiblement dans le plan de la couche, sensiblement perpendiculaire à l'axe facile d'aimantation Ox de la couche de stockage 101 permettant de définir les deux états stables d'aimantation et dans un sens donné par $\left(\vec{J}\times\vec{M}_{initiale}\right)\vec{H}_y$ du même signe que la composante de l'aimantation 111 du polariseur perpendiculaire suivant l'axe Oz définie sur les figures 8 et 9, cet axe Oz allant du polariseur perpendiculaire 103 vers la couche de stockage 101. $\vec{M}_{initiale}$ représente ici l'état initial de la couche de stockage (c'est-à-dire $\vec{M}_{sto}$ dans le premier ou second état stable) et J représente le vecteur de densité de courant pour faire commuter l'aimantation de la couche de stockage 101 de l'état initial stable avant écriture à l'état final stable après écriture.

La condition ci-dessus sur $\left(\vec{J} \times \vec{M}_{initiale}\right)\vec{H}_y$ laisse deux possibilités de choix concernant l'orientation de Hy et le sens correspondant des pulses de courant. On peut en effet à la fois changer le signe de Hy et de J en satisfaisant la même condition.

Toutefois, si on considère maintenant que l'empilement du dispositif 200 de la figure 10 (polariseur perpendiculaire 203 /espaceur non-magnétique 202 /couche de stockage 201) constitue l'électrode inférieure d'une jonction tunnel magnétique polariseur perpendiculaire 203 /espaceur non-magnétique 202 /couche de stockage 201 /barrière tunnel 209 / couche de référence 208, il apparait que sur les deux directions possibles de Hy et du sens des courants d'écriture, un choix est préférentiel par rapport à l'autre. En effet, dans la situation de la figure 8, si on rajoute en plus l'analyseur planaire (figure 10), la commutation de l'aimantation de la couche de stockage sera favorisée par le transfert de spin exercé par l'analyseur planaire piégé sur l'aimantation de la couche de stockage si l'aimantation de l'analyseur planaire est vers la droite. Il en est de même dans la situation de la figure 9. Ainsi pour un sens donné de l'orientation du polariseur perpendiculaire (parallèlement ou antiparallèlement à l'axe z) et pour un sens donné de l'aimantation de l'analyseur planaire (un sens ou le sens opposé suivant l'axe facile d'aimantation de la couche de stockage), l'orientation préférée du champ transverse permettant de bénéficier à la fois de l'action du polariseur perpendiculaire et de l'analyseur planaire est celle qui satisfait à l'inégalité : $\left(\vec{M}_{analyseurplanaire} \times \vec{P}\right)\vec{H}_y > 0$ .

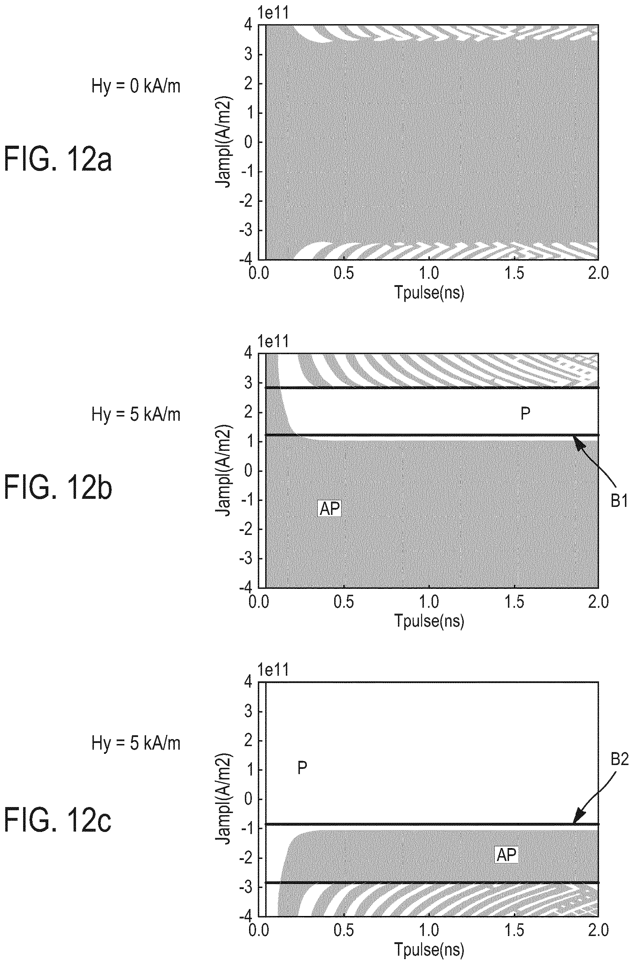

Dans ce qui suit, les figures 12 (12a à 12c) à 17 illustrent différents comportements dynamiques de l'aimantation de la couche de stockage en fonction de différents paramètres (densité de courant traversant l'empilement, valeur du champ transverse, durée du pulse de courant). Ces figures ont été obtenues dans des conditions particulières d'épaisseur de couche de stockage, polarisation du courant délivré par le polariseur perpendiculaire, amortissement de Gilbert, aimantation, anisotropie planaire. Ces figures sont donc données à titre illustratif pour expliquer l'influence bénéfique de l'application d'un champ transverse sur le contrôle de la dynamique de commutation de l'aimantation de la couche de stockage soumise au couple de transfert de spin dû au polariseur perpendiculaire. Les conditions utilisées dans ces figures correspondent à une couche de stockage de 3nm d'épaisseur, une aimantation spontanée $M_S$=1.2e6 A/m, un amortissement de Gilbert de $\alpha$=0.02 et un champ d'anisotropie uniaxiale dans le plan de 8.5 kA/m.

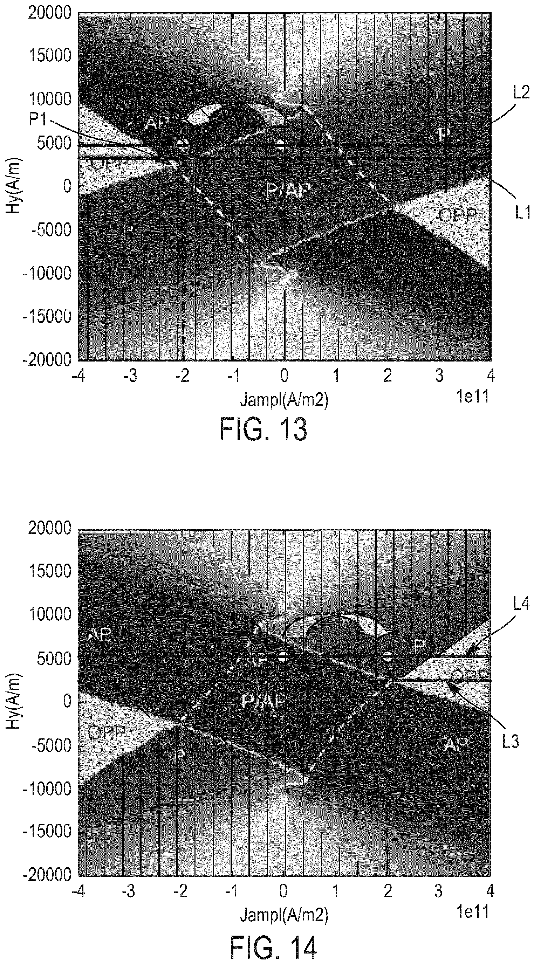

S'agissant de l'amplitude du champ transverse ainsi que l'amplitude de la densité de courant, les figures 12a à 12c et la figure 13 illustrent comment ces amplitudes doivent être choisies.

Tout d'abord, les figures 12a à 12c illustrent comment l'amplitude de la densité de courant d'écriture doit être choisie pour une valeur donnée du champ transverse pour commuter de l'état antiparallèle AP à l'état parallèle P ou de l'état P à l'état AP avec ou sans probabilité oscillante. Sur chacune de ces figures 12a à 12c, la zone foncée correspond à 100% de probabilité d'être dans l'alignement parallèle P et la zone claire, à 100% de probabilité d'être dans l'alignement antiparallèle AP. En l'absence de champ transverse (figure 12a), comme déjà discuté en référence à la figure 5, dès que la densité de courant (échelle des ordonnées) dépasse une valeur seuil liée à l'anisotropie planaire de la couche de stockage, l'aimantation part en mouvement de précession ce qui conduit à une probabilité oscillante en fonction de la durée des pulses. Ceci se traduit par une alternance de bandes foncées et claires en fonction de la durée des pulses. La façon de calculer le seuil de densité de courant pour déclencher le mouvement de précession de l'aimantation a notamment été décrite dans l'article «Analytical investigation of spin-transfer dynamics using a perpendicular-to-plane polarizer » (KJ Lee et al., APPLIED PHYSICS LETTERS 86, 022505 (2005), formule 6). Ce seuil est proportionnel au champ d'anisotropie planaire de la couche (le plus souvent déterminé par l'anisotropie de forme du point mémoire de forme allongée par exemple elliptique), proportionnel à l'épaisseur de la couche de stockage et à son aimantation.

En présence d'un champ transverse, les figures 12b et 12c montrent que la situation change. Il apparait alors deux bandes B1 et B2 sensiblement comprise entre $1.10^{11}$ et $3.10^{11}$ A/m$^2$ de valeurs de densités de courant pour lesquelles on peut commuter de AP vers P (figure 12b) et de P vers AP (figure 12c) avec la même amplitude de champ transverse Hy (ici 5 kA/m), juste en inversant le sens du pulse de courant traversant l'empilement. Ces bandes B1 et B2 sont délimitées sur ces figures par deux traits. Les figures 12b et 12c montrent que dans cet intervalle de densité de courant, l'état final de l'aimantation de la couche de stockage est indépendant de la durée du pulse à partir du moment où cette durée dépasse une durée de l'ordre de 100 à 200ps. On a donc une commutation magnétique bien inférieure à la nanoseconde sans avoir à contrôler très précisément la durée du pulse de courant. En revanche, on constate que si la densité de courant devient trop importante et sort de la bande B1 ou B2 délimitée par les traits, on retombe à nouveau dans un régime de probabilité oscillante dans lequel l'état final dépend de la durée du pulse.

En d'autres termes, pour une valeur de champ magnétique transverse donnée, la valeur de la densité de courant traversant le dispositif selon l'invention doit être préférentiellement choisie pour rester dans une gamme assurant de façon certaine la commutation de l'aimantation de la couche de stockage de l'état initial correspondant à une position d'équilibre avant écriture à l'état final correspondant à une deuxième état d'équilibre après écriture.

S'agissant du choix de l'amplitude du champ transverse Hy, les figures 13 et 14 représentent les diagrammes de stabilité de l'aimantation de la couche de stockage sous l'influence du transfert de spin du polariseur perpendiculaire en présence d'un champ magnétique transverse. Les figures 13 et 14 illustrent comment le champ transverse Hy doit être choisi. Sur ces figures, l'axe vertical des ordonnées est le champ transverse Hy et l'axe horizontal des abscisses représente la densité de courant Jampl circulant à travers le dispositif selon l'invention. Les différents codes (pointillés, hachures, traits verticaux, traits verticaux superposés à des hachures) représentent les différentes configurations du dispositif dans l'état final. :

- Dans les zones de traits verticaux - zones P -, l'aimantation est proche uniquement de la configuration parallèle. Par proche de la configuration parallèle, on entend que l'angle entre les aimantations de la couche de stockage et celle de la couche de référence est inférieur à 90°. Lorsque le champ transverse augmente, cet angle a d'abord tendance à augmenter puisque l'aimantation de la couche de stockage va tendre à tourner vers le champ transverse appliqué alors que l'aimantation de la couche de référence reste orientée sensiblement dans sa direction de piégeage. Toutefois lorsque le champ transverse est suffisamment fort par rapport au champ de piégeage de l'aimantation de la couche de référence, cette dernière va tendre aussi à tourner vers le champ transverse de sorte que l'angle entre les aimantations des couches de stockage et de référence diminue à nouveau.. Le niveau de gris sur le fond des figures 13 et 14 est lié à la valeur absolue du cosinus de l'aimantation de la couche de stockage : gris foncé dans la zone P signifie que l'aimantation de la couche de stockage est proche de son axe facile d'aimantation (orientation à 0°) ; gris clair signifie que l'aimantation de la couche de stockage s'écarte de la direction de l'axe facile d'aimantation pour se rapprocher d'une orientation à 90° de l'axe facile d'aimantation.

- Dans les zones de hachures - zone AP- Par proche de la configuration antiparallèle, on entend que l'angle entre les aimantations de la couche de stockage et celle de la couche de référence est compris entre 90° et 180°.,. Faisant référence au niveau de gris sur le fond des Figures 13 et 14, gris foncé dans la zone AP signifie que l'aimantation de la couche de stockage est proche de son axe facile d'aimantation (orientation à 180°) ; gris clair signifie que l'aimantation de la couche de stockage s'écarte de la direction de l'axe facile d'aimantation pour se rapprocher d'une orientation à 90° de l'axe facile d'aimantation.

- Dans la zone à traits verticaux superposés à des hachures - zones P/AP-, l'aimantation est bistable, c'est-à-dire qu'elle peut être stabilisée dans l'une des deux configurations en fonction des événements vécus antérieurement ;

- Dans les zones en pointillés - zone OPP-, l'aimantation est instable. La désignation OPP signifie « Out-of-Plane Precession » qui correspond au régime de précession entretenue.

De façon générale, plus on augmente Hy, plus les aimantations s'écartent de leur axe facile d'aimantation car elles sont tirées dans une direction perpendiculaire par le champ transverse Hy.

La figure 13 illustre le diagramme pour un état initial parallèle P tandis que la figure 14 illustre le diagramme pour un état initial antiparallèle AP.

Comme illustré sur la figure 13, pour pouvoir commuter de l'état P à l'état AP en présence d'un champ transverse, il faut que le champ transverse soit au-dessus de la ligne L1 horizontale passant par le point P1 le plus bas d'intersection entre la zone P/AP et la zone AP. Si le champ transverse a cette valeur critique alors la gamme de densité de courant permettant d'aboutir à l'état AP sans partir en précession entretenue est très étroite (voire quasi réduite à une seule valeur, ici égale à un pulse de courant négatif de l'ordre de $-2.10^{11}$ A/m$^2$). On a donc intérêt à choisir un champ transverse suffisamment au-dessus (par exemple correspondant à la ligne L2) de cette valeur critique donnée par la ligne L1 pour voir un intervalle de valeur de densité de courant possible plus large (ici typiquement entre $-1.10^{11}$ et $- 3.10^{11}$ A/m$^2$) pour s'éloigner des deux lignes critiques correspondantes d'un côté à l'absence de commutation (ligne L1) et de l'autre côté la ligne critique séparant la zone AP de la zone correspondant au régime de précession entretenue. Toutefois, le champ transverse ne doit pas être trop élevé vis-à-vis du champ d'anisotropie planaire car ce champ transverse, s'il est appliqué en permanence, tend à écarter l'aimantation de la couche de stockage par rapport à sa direction de facile aimantation ce qui fait que le système n'est plus parfaitement dans l'état P ou AP mais dans des états intermédiaires d'alignement relatif des aimantations des couches de référence et de stockage. Nous reviendrons sur ce phénomène dans la suite de la description mais ceci explique pourquoi on retrouve une configuration à 90° de l'aimantation de la couche de stockage si le champ transverse devient trop grand à faible densité de courant (ou à densité de courant nulle).

Il en de même pour la figure 14 qui montre qu'un même champ transverse que pour passer de l'état P à l'état AP peut être utilisé pour passer de l'état AP vers l'état P grâce à un pulse de courant sensiblement de même valeur mais de sens opposé c'est-à-dire positif ici.

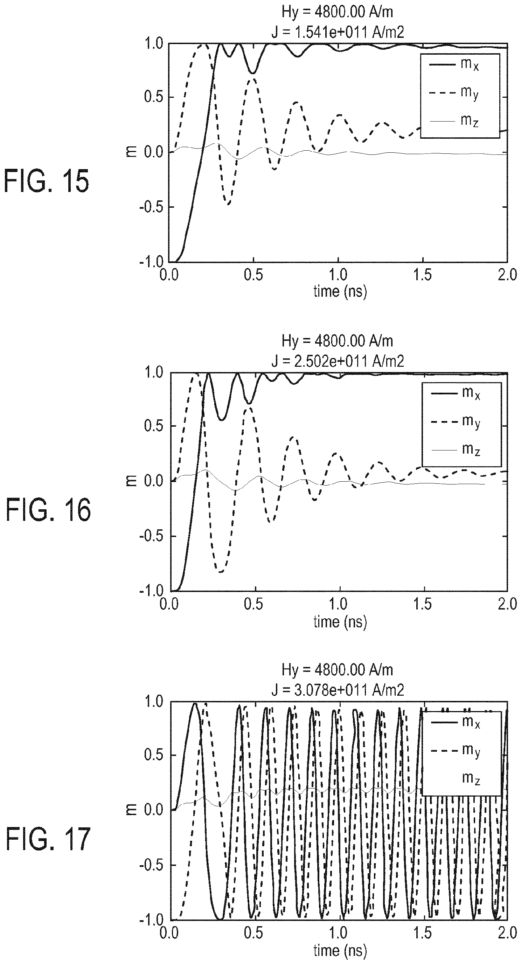

Les figures 15 à 17 illustrent la variation temporelle des composantes mx, my et mz (correspondant au repère Oxyz de la figure 10) de l'aimantation de la couche de stockage. La composante mx correspond à la composante de l'aimantation suivant Ox de sorte que lorsque la composante mx est égale à +1, cela correspond à l'état P et lorsque la composante mx est égale à -1, cela correspond à l'état AP. Les trois graphes sont obtenus pour le même champ transverse Hy=4800A/m et trois valeurs croissantes de la densité de courant traversant la jonction tunnel magnétique (respectivement $1.541.10^{11}$ A/m², $2.502.10^{11}$ A/m² et $3.078.10^{11}$ A/m² pour les figures 15, 16 et 17). Les figures 15 à 17 donnent des exemples de variation en temps réel des composantes d'aimantation de la couche de stockage sous l'effet du transfert de spin dû au polariseur perpendiculaire en présence d'un champ transverse pour des densités de courant de trois amplitudes différentes.

La figure 15 montre que pour un champ transverse de Hy=4800A/m, l'aimantation de la couche de stockage commute très rapidement de l'état AP vers l'état P pour une densité de courant de $1.541$ $10^{11}$A/m². La figure 16 montre que pour un champ transverse de Hy=4800A/m, l'aimantation de la couche de stockage commute encore plus rapidement pour une densité de courant plus élevée de $2.502$ $10^{11}$A/m². La commutation est suivie par de petites oscillations d'aimantation autour de la position finale d'équilibre mais pas de commutation en retour vers l'état initial. La commutation se fait sensiblement en 500ps pour $1.541$ $10^{11}$A/m² et en sensiblement 350ps pour $2.502$ $10^{11}$A/m². D'une façon générale, la vitesse de commutation augmente avec la densité de courant mais cette dernière ne doit pas être trop élevée ; en effet, si la densité de courant est trop élevée, l'aimantation de la couche de stockage passe dans un régime de précession entretenue comme illustré sur la figure 17, qui fait apparaitre une oscillation entretenue des composantes d'aimantation de la couche de stockage traduisant ce mouvement de précession (rotation) entretenu d'aimantation. Le régime recherché selon l'invention est donc celui illustré sur les figures 15 et 16.

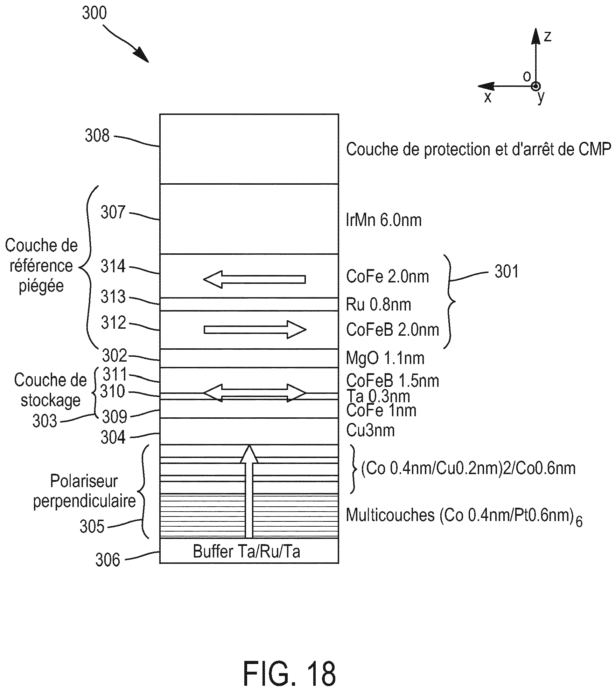

Les figures 18 à 20 illustrent trois exemples d'empilement magnétique utilisable pour le dispositif selon l'invention.

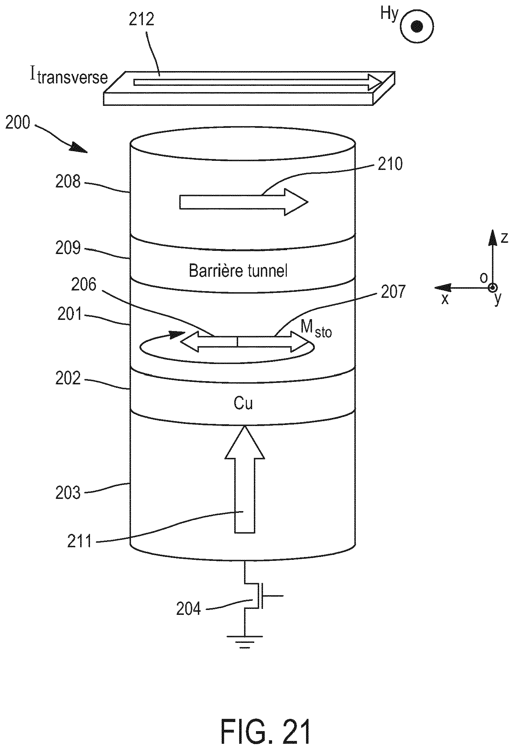

Par soucis de simplification, les amenées de courant et les moyens de commutation de courant permettant de faire circuler un courant électrique perpendiculairement au plan de l'empilement de couches magnétiques ont été volontairement omis dans la description des figures 18 à 20 qui suivent. De même, les moyens pour appliquer un champ magnétique transverse au moins pendant la phase d'écriture pour passer d'une position d'équilibre de la direction d'aimantation de la couche de stockage à l'autre seront décrits plus tard en référence aux figures 21 et 23 à 26.

La figure 18 représente un premier mode de réalisation d'un dispositif magnétique 300 selon l'invention.

Le dispositif magnétique 300 comporte un empilement formé par:

- une couche de protection 308 ;
- une couche de piégeage antiferromagnétique 307 ;
- une couche magnétique de référence 301 de direction d'aimantation fixe (ici située dans le plan de la couche de référence) ;
- un premier espaceur non magnétique 302 ;
- une couche magnétique de stockage 303 de direction d'aimantation réorientable suivant deux états d'orientation sensiblement opposées (deux positions d'équilibre sensiblement suivant un axe facile d'aimantation Ox défini par la direction d'aimantation fixe de la couche de référence 301) ;
- un second espaceur non magnétique 304 ;
- une couche 305 de polarisation de spin d'électrons, ayant une aimantation hors du plan de la couche de polarisation et de direction perpendiculaire à celle de la couche de référence 301 ;
- une couche tampon 306.

La couche de stockage 303 est une couche à aimantation dans le plan de la couche aimantation de direction variable et possédant deux positions d'équilibre sensiblement suivant l'axe défini par la direction d'aimantation fixe de la couche de référence 301 dont la direction d'aimantation est fixe 301 dans le plan de la couche de référence suivant l'axe Ox. Dans le cas d'empilement magnétorésistif ayant un premier espaceur non magnétique 302 qui est une barrière tunnel de MgO (ici de 1.1 nm) ayant une structure cristallographique bcc (« body centered cubic »), cette couche de stockage 303 doit aussi de façon préférentielle avoir près de l'interface avec le premier espaceur 302 une structure bcc. On choisit alors un alliage à base de Co, de Fe et de Ni de structure bcc ou un alliage CoFeB amorphe que l'on recuira ensuite. La couche de stockage 303 peut ainsi être composée de 3 couches formant un seul bloc magnétique : une couche magnétique de CoFe 309 (de 1nm) de structure fcc (face-centered cubic ») au-dessus du second espaceur non magnétique 304, une fine couche de Ta 310 (de 0.3nm) servant à assurer une transition structurale de fcc à bcc et à absorber le B de la couche de CoFeB adjacente (ces modes de fabrication bien connus de l'homme de l'art travaillant sur la croissance des jonctions tunnel à base de MgO), et une couche 311 de CoFeB (de 1.5nm) qui cristallise en CoFe bcc au contact de la barrière de MgO au moment du recuit suivant le dépôt de cet empilement. Selon ce premier mode de réalisation, la couche de stockage 303 est une couche ferromagnétique simple (simple dans le sens où elle est formée d'un seul « bloc » magnétique par opposition à un synthétique antiferromagnétique).

La barrière tunnel 302 est surmontée de la couche de référence 301 piégée qui est avantageusement constitué d'une couche synthétique antiferromagnétique (CoFeB/Ru/CoFe) au lieu d'une couche simple de CoFeB, ceci afin de minimiser le champ magnétostatique rayonné par cette couche de référence 301 sur la couche de stockage 303. En d'autres termes, la couche de référence 301 est ici une couche antiferromagnétique synthétique comprenant deux couches ferromagnétiques 314 et 312 couplées antiparallèlement à travers une fine couche 313 de couplage antiparallèle, par exemple en ruthénium d'épaisseur 0.8nm. Dans le cas où le premier espaceur non magnétique 302 est une barrière tunnel de MgO, cette couche de référence 301 antiferromagnétique synthétique comprend une couche 312 de CoFeB d'épaisseur entre 2nm en contact avec la barrière 302 de MgO, une couche 313 de ruthénium d'épaisseur 0.8nm et une couche 314 de CoFe d'épaisseur typique de 2nm. Cette dernière couche magnétique 314 est ici piégée par la couche antiferromagnétique 307 par exemple en Ir20Mn80 d'épaisseur 6nm ou en PtMn.

La couche de piégeage antiferromagnétique 307 est recouverte par la couche de protection 308 servant à la protéger de l'oxydation lors de l'exposition à l'air pendant le procédé de fabrication et servant également de contact électrique avec l'électrode supérieure de l'empilement.

Comme évoqué plus haut, l'intérêt d'utiliser une couche synthétique antiferromagnétique est de minimiser le champ magnétostatique rayonné par la couche de référence 301. Ce champ est en effet approximativement suivant l'axe facile d'aimantation de la couche de stockage 303 et a pour effet de rendre dissymétrique la stabilité thermique des états P et AP en favorisant une orientation de l'aimantation de la couche de stockage 303 parallèlement à ce champ rayonné. Il faut donc minimiser ce champ rayonné par la couche de référence 301 sur la couche de stockage 303 est cela peut être fait grâce à une couche synthétique antiferromagnétique correctement équilibrée pour que les champs rayonnés par chacune des deux couches constitutives 312 et 314 au niveau de la couche de stockage 303 se compensent. Cette couche synthétique antiferromagnétique de référence 301 est elle-même piégée par une couche antiferromagnétique 307. Comme cela est bien connu de l'homme du métier, la structure doit être recuite après dépôt pour faire cristalliser la barrière tunnel et les électrodes magnétiques et pour orienter l'anisotropie d'échange produite par la couche antiferromagnétique sur la couche de référence 301 sensiblement parallèlement à l'axe facile d'aimantation de la couche de stockage 303.

Le premier espaceur 302 peut être une barrière tunnel à base de MgO, d'alumine, d'HfOx ou de TiOx.

La couche 305 de polarisation de spin d'électrons est ici séparée de la jonction tunnel magnétique formée par la couche de référence 301, la barrière tunnel 302 et la couche de stockage 303 par un second espaceur non magnétique 304 pouvant être :

- un espaceur métallique, par exemple en Cu ou en Or ;
- une barrière tunnel de plus faible produit RA (produit résistance*aire) que celle constituant le premier espaceur 302. Elle peut être constituée du même matériau que le premier espaceur 302 (par exemple en MgO) mais de moindre épaisseur ou d'un matériau différent, de préférence de plus faible hauteur de barrière pour que sa résistance électrique soit moindre de celle du premier espaceur 302 ;
- une couche à chemins de courant confinés. Une telle couche est constituée d'une couche isolante percée de chemins conducteurs de diamètre typiquement de 1 à quelques nanomètres. Une telle couche est par exemple formée par oxydation d'un alliage Al99Cu1. Au cours de l'oxydation, l'aluminium s'oxyde en AlOx tandis que le cuivre qui est moins oxydable que l'aluminium coalesce en petits clusters formant les chemins conducteurs. En jouant sur la densité et la taille des chemins conducteurs, on peut ajuster le produit RA à la valeur souhaitée.

La couche 305 de polarisation de spin d'électrons a une aimantation hors du plan de la couche de polarisation et de direction perpendiculaire à celle de la couche de référence 301.

La couche de polarisation ou polariseur perpendiculaire 305 est par exemple une couche ferromagnétique ou une multicouche simple.

Comme représenté sur la figure 18, le polariseur perpendiculaire 305 peut comprendre une multicouche de période (Co/Pt) (par exemple Co0.4nm/Pt0.6nm avec 6 répétitions) à forte anisotropie perpendiculaire couplée à une couche de Co de 0.6nm comprenant des laminations très fines de cuivre permettant de réduire la longueur de diffusion de spin dans cet empilement (Co/Cu) (par exemple deux répétitions de Co0.4nm/Cu0.2nm) de sorte que la polarisation en spin du courant puisse se construire sur la faible épaisseur de ce polariseur perpendiculaire.

La couche tampon 306 a pour but de promouvoir la croissance de l'ensemble de la structure et d'établir le contact électrique avec l'électrode inférieure. Il peut s'agir de couches de CuN, de Ta, de NiFeCr, de Ru, de Pt, de Cu, d'une multicouche Ta/Ru/Ta. L'épaisseur de cette couche 306 peut varier de 1 à quelques centaines de nm.

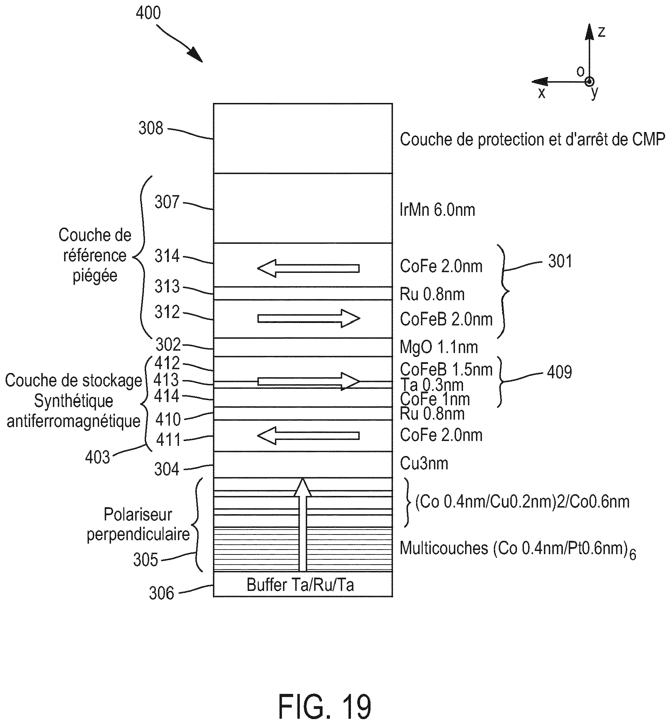

La figure 19 représente un second mode de réalisation d'un dispositif magnétique 400 selon l'invention. Le dispositif 400 est quasi identique au dispositif 300 de la figure 18 (les éléments communs présentent d'ailleurs les mêmes numéros de référence) à l'exception de la réalisation de la couche de stockage 403 qui diffère de la couche 303 du dispositif 300.

La couche 403 est ici une couche de stockage antiferromagnétique synthétique, c'est-à-dire composée de deux couches ferromagnétiques 409 et 411 couplées antiparallèlement à travers une couche de couplage antiparallèle 410 comme de ruthénium d'épaisseur 0.8nm. Ce faisant, on augmente le volume de la couche de stockage 403 et on rend également plus uniforme son champ interne. De ce fait, la commutation d'aimantation par transfert de spin se produit de façon plus cohérente ce qui permet d'abaisser le courant critique de retournement. Une telle couche 403 permet d'augmenter la stabilité thermique de l'aimantation de la couche de stockage et donc la rétention de la mémoire. Elle permet de réduire encore davantage l'interaction magnétostatique avec la couche de référence. Elle permet aussi d'avoir un comportement plus « macrospin » de l'aimantation de la couche de stockage lors de la commutation magnétique c'est-à-dire que cette aimantation commute plus comme un bloc rigide grâce à un phénomène de fermeture de flux magnétique entre les deux couches magnétiques couplées anti-ferromagnétiquement constitutives de cette couche de stockage. Cette fermeture de flux fait que le champ interne dans la couche de stockage est plus homogène ce qui conduit à cette commutation plus cohérente et donc plus reproductible d'un événement d'écriture à l'autre.

En ce qui concerne l'orientation référentielle de la direction du champ transverse, l'homme de l'art comprendra aisément que par rapport à la discussion de la Figure 10, la situation est inversée si on utilise une couche de stockage synthétique antiferromagnétique. En effet, dans ce cas, pour un sens donné de l'orientation du polariseur perpendiculaire (parallèlement ou antiparallèlement à l'axe z) et pour un sens donné de l'aimantation de l'analyseur planaire (un sens ou le sens opposé suivant l'axe facile d'aimantation de la couche de stockage), l'orientation préférée du champ transverse permettant de bénéficier à la fois de l'action du polariseur perpendiculaire et de l'analyseur planaire est celle qui satisfait à l'inégalité : $\left(\vec{M}_{analyseurplanaire} \times \vec{P}\right)\vec{H}_y < 0$ .

La couche 409 est identique à la couche 303 de la figure 18 et est donc composée de 3 couches formant un seul bloc magnétique : une couche magnétique de CoFe 412 (de 1nm) de structure fcc (face-centered cubic ») au-dessus du second espaceur non magnétique 304, une fine couche de Ta 413 (de 0.3nm) servant à assurer une transition structurale de fcc à bcc et à absorber le B de la couche de CoFeB adjacente, et une couche 414 de CoFeB (de 1.5nm) qui cristallise en CoFe bcc au contact de la barrière de MgO.

La couche 411 est par exemple une couche de CoFe d'épaisseur typique de 2nm en contact avec le deuxième espaceur 304.

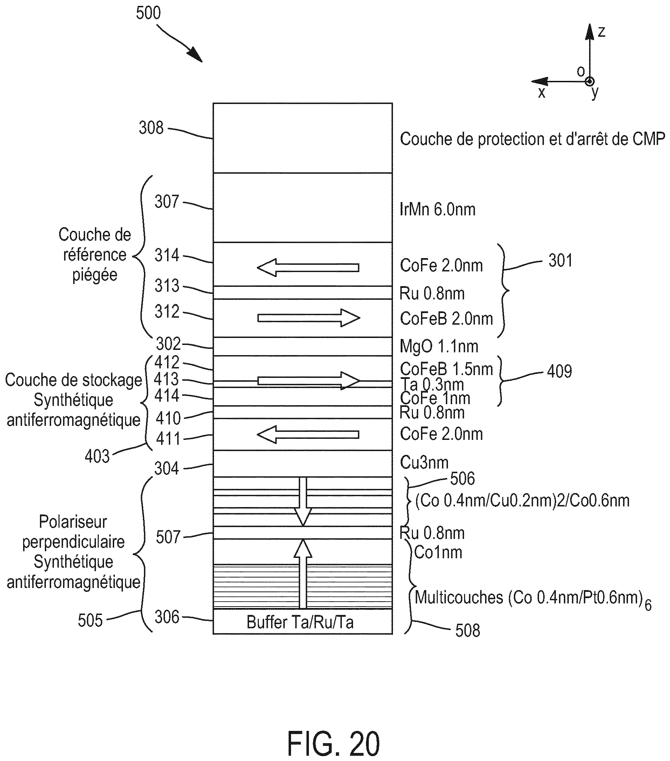

La figure 20 représente un troisième mode de réalisation d'un dispositif magnétique 500 selon l'invention. Le dispositif 500 est quasi identique au dispositif 400 de la figure 19 (les éléments communs présentent d'ailleurs les mêmes numéros de référence) à l'exception de la réalisation de La couche de polarisation de spin d'électrons 505 qui diffère de la couche 305 du dispositif 400.

Le polariseur perpendiculaire 505 est ici une couche dite antiferromagnétique synthétique constituée de deux couches 506 et 508 d'aimantation fixe orientée hors du plan et couplées antiparallèlement par une couche 507 apte à induire un couplage antiferromagnétique entre les couches ferromagnétiques adjacentes comme par exemple une fine couche de Ruthénium d'épaisseur 0.8nm.

La couche 508 a une aimantation hors du plan de la couche de polarisation et de direction perpendiculaire à celle de la couche de référence 301 et est par exemple constituée par une multicouche simple de période (Co/Pt) (par exemple Co0.4nm/Pt0.6nm avec 6 répétitions) à forte anisotropie perpendiculaire couplée à une couche de Co de 0.6nm.

La couche 506 a également une aimantation hors du plan de la couche de polarisation et de direction perpendiculaire à celle de la couche de référence 301 antiparallèle à l'aimantation de la couche 508. La couche 506 est par exemple réalisée par une couche d'aimantation fixe de composition (Co 0.4nm/Cu 0.2nm)$_2$/Co 0.6nm.

L'avantage de remplacer la couche unique d'aimantation fixe par une telle structure antiferromagnétique synthétique est de rendre l'aimantation de la couche d'aimantation fixe encore plus piégée et donc résistante aux perturbations magnétiques. Ceci réduit à nouveau le champ hors du plan rayonné par le polariseur perpendiculaire sur l'aimantation de la couche de stockage. Ce champ hors du plan nuit à la stabilité thermique de l'aimantation de la couche de stockage et donc à la rétention et nuit aussi sur la cohérence de la commutation magnétique comme expliqué par exemple dans la publication « Improved coherence of ultrafast spin-transfer-driven precessional switching with synthetic antiferromagnet perpendicular polarizer » (Vaysset et al., Applied Physics Letters 98 (2011) 242511).

Il est entendu que les empilements décrits ci-dessus pourraient être réalisés en renversant toutes les couches en bloc et donc en mettant le polariseur perpendiculaire au sommet de l'empilement et la couche de référence en bas de l'empilement.

La suite de la description concerne différents modes de réalisation permettant d'obtenir les moyens 105 et 205 des figures 7 et 10 pour appliquer, au moins pendant la phase d'écriture pour passer d'une position d'équilibre de la direction d'aimantation de la couche de stockage à l'autre, le champ transverse, dont la direction est sensiblement parallèle au plan de la couche de stockage et sensiblement perpendiculaire à l'axe facile d'aimantation de ladite couche de stockage.

Selon un premier mode de réalisation illustré en figure 21 qui représente le dispositif 200 de la figure 10, les moyens pour appliquer le champ transverse Hy peuvent permettre d'appliquer ledit champ uniquement (i.e. temporairement) pendant l'écriture.

Pour ce faire, on rajoute une ligne conductrice 212 au-dessus ou en-dessous du dispositif 200 comme cela est connu de l'homme du métier pour les mémoires à écriture par champ (comme par exemple les mémoires de type « Toggle » développées par la société Everspin ou les mémoires à écriture assistée thermiquement développées par la société Crocus Technology). Le champ est alors produit en envoyant un courant I$_{transverse}$ à travers cette ligne conductrice 212 suivant le théorème d'Ampère. Pour que le champ Hy créé soit transverse à l'axe facile d'aimantation de la couche de stockage 201 (grand axe de l'ellipse si la jonction tunnel a une forme elliptique), il faut que la ligne 212 de génération du champ soit sensiblement parallèle à cet axe facile d'aimantation.

L'inconvénient d'une telle approche consistant à créer un champ uniquement pendant l'écriture est la consommation électrique associée à la création du champ. Pour créer un champ sensiblement égal à 5000A/m, il faut un courant de 5 à 10mA ce qui est important en microélectronique et empêcherait de réaliser des mémoires très denses utilisant cette technologie.

Dès lors, il peut être plus facile techniquement et moins consommateur d'énergie d'appliquer le champ transverse en permanence grâce à une couche de matériau dur ou d'aimantation piégée située à proximité de la jonction tunnel et même intégrée dans l'empilement de la jonction tunnel comme illustré sur les figures qui vont être décrites dans ce qui suit. Dans ce cas, Le principe repose sur le fait d'utiliser comme champ transverse le champ rayonné par une couche de type aimant permanent, l'aimantation restant sensiblement inchangée pendant tout le fonctionnement du dispositif. L'avantage est que dans ce cas il n'y a aucune consommation énergétique associée à la création du champ transverse. Il existe toutefois deux inconvénients mineures associés à cette approche.

Tout d'abord, la présence de ce champ transverse permanent réduit la stabilité thermique de l'aimantation de la couche de stockage en réduisant la hauteur de barrière séparant les deux états stables d'aimantation. Ceci peut rester néanmoins tout à fait acceptable pour des mémoires rapides (de l'ordre de la sub-nanoseconde) visant des applications de type SRAM qui ne nécessitent pas forcément de longues rétentions (parfois des rétentions de 1s peuvent être suffisantes).

L'autre inconvénient est une légère diminution de l'amplitude de magnétorésistance tunnel au moment de la lecture. En effet, du fait de la présence du champ transverse, l'aimantation de la couche de stockage n'est plus parfaitement en alignement parallèle ou antiparallèle.

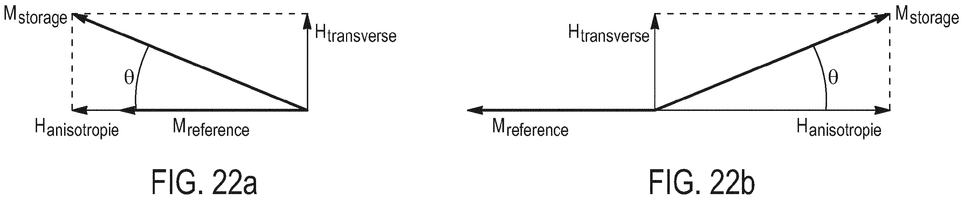

La perte de magnétorésistance peut être aisément calculée à partir de l'angle de déviation de l'aimantation de la couche de stockage par rapport à l'axe facile d'aimantation liée à l'application du champ transverse. Ce phénomène est illustré sur les figures 22a (déviation de l'aimantation de la couche de stockage par rapport à un état parallèle) et 22b (déviation de l'aimantation de la couche de stockage par rapport à l'état antiparallèle). L'énergie de l'aimantation de la couche de stockage soumise à son anisotropie (caractérisée par la constante d'anisotropie par unité de volume K) et au champ transverse s'écrit $E = -K \cos^2 \theta - MsH_y \sin\theta$ où $\theta$ est l'angle entre l'aimantation de la couche de stockage et son axe facile d'aimantation, Ms l'aimantation de cette couche et Hy le champ transverse. La minimisation de cette énergie conduit à $$\sin\theta = \frac{MsH_y}{2K}.$$ Le champ transverse doit être suffisamment petit par rapport à $$H_K = \frac{2K}{Ms}$$ pour que l'angle de déviation ne soit pas trop grand et ne réduise pas trop la magnétorésistance tunnel. La conductance G varie en fonction de l'angle entre aimantation de la couche de référence et de stockage comme

$$G(\theta) = G_P - \Delta G \frac{(1-\cos\theta)}{2}$$ où $\Delta G$ représente la variation de conductance (magnétoconductance) entre alignement P et AP parfait : $\Delta G = G(0) - G(\pi) = 1/R(0) - 1/R(\pi)$, R étant la résistance de la jonction tunnel c'est-à-dire l'inverse de sa conductance.

En présence du champ transverse Hy, l'angle de l'aimantation varie de $\theta$ à $\pi - \theta$ au lieu de varier de 0 à $\pi$. Il en résulte que la magnétoconductance effective $\Delta G_{eff}$ est donnée par

$$\Delta G_{eff} = \Delta G \sqrt{1 - \left(\frac{M_s H_y}{2K}\right)^2} = \Delta G \sqrt{1 - \left(\frac{H_y}{H_K}\right)^2}.$$

L'effet du champ transverse sur l'amplitude de magnétoconductance n'est pas très important en pratique. Par exemple, pour une jonction tunnel de forme elliptique, Hk peut prendre des valeurs de l'ordre de 15000A/m. Si Hy vaut 5000A/m alors $\Delta G_{eff} = 0.94 \Delta G$ ce qui signifie que la magnétorésistance tunnel et/ou la magnétoconductance tunnel (les deux sont équivalentes en amplitude puisque mathématiquement $$\frac{\Delta R}{R_P} = \frac{\Delta G}{G_{AP}})$$ baissent en valeur relative de 6% entre l'absence de champ transverse et la présence d'un champ transverse égal à 1/3 du champ d'anisotropie. Une telle réduction est tout à fait acceptable au regard du bénéfice tiré en terme de contrôle de la dynamique de commutation et de contrôle de l'état final que l'on veut écrire dans le point mémoire.

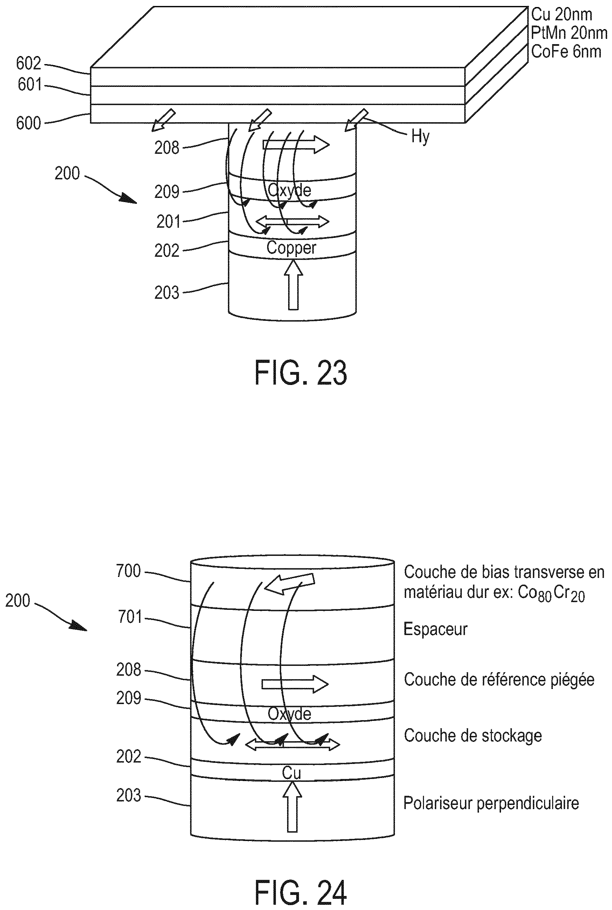

Pour créer un champ transverse permanent sur la couche de stockage, plusieurs solutions sont possibles comme illustré sur les figures 23 à 26. Les différents modes de réalisation des moyens 205 pour appliquer un champ transverse permanent seront illustrés au regard du dispositif 200 de la figure 10 étant entendu que ces moyens peuvent être utilisés pour d'autres structures de l'empilement du dispositif selon l'invention, par exemple dans le cas des figures 18 à 20. Le principe général est de créer ce champ permanent à l'aide d'un matériau dur ou d'aimantation piégée dont le champ rayonné au niveau de la couche de stockage constitue le champ transverse permanent.

Une première façon de créer ce champ permanent est illustré sur la figure 23. Elle consiste à intégrer au-dessus de la couche de référence 208, une couche magnétique 600 par exemple constituée d'un alliage cobalt-fer d'une épaisseur de 6nm et une couche antiferromagnétique 601 de piégeage, par exemple en PtMn sur une épaisseur de 20 nm, les deux couches 600 et 601 étant au-dessous de la ligne conductrice 602 (par exemple en Cu) connectant électriquement une des électrodes du dispositif selon l'invention. La couche 600 de matériau à forte aimantation est piégée par anisotropie d'échange. Comme mentionné plus haut, la couche de référence 208 est le plus souvent elle-même piégée par une couche antiferromagnétique de piégeage (par exemple une couche d'IrMn comme illustrée sur les figures 18 à 20).

Comme la couche de référence 208 et la couche 600 servant à créer le champ transverse Hy doivent être piégée dans deux directions différentes (l'une parallèlement à l'axe facile d'aimantation de la couche de stockage 201, l'autre transversalement à cette direction), on peut utiliser deux couches antiferromagnétiques de piégeage présentant des températures de blocage différentes pour l'une et l'autre couche, par exemple une couche non représentée d'IrMn (dont la température de blocage est $T_{B\ IrMn} \sim 230°C$) pour piéger la couche de référence et une couche 601 en PtMn (dont la température de blocage est $T_{B\ PtMn} \sim 320°C$) pour piéger la couche de création du champ transverse Hy.

Ainsi, la couche antiferromagnétique 601 (PtMn) présente une température de blocage supérieure à la couche antiferromagnétique de piégeage de la couche de référence. Le fait d'avoir des températures de blocage différentes permet notamment d'orienter successivement les aimantations de la couche de formation du champ transverse puis de la couche de référence. Il est à noter qu'on pourrait au contraire orienter en premier l'aimantation de la couche de référence puis en second celle de la couche d'application du champ transverse. Il faudrait alors que la température de blocage de la couche antiferromagnétique de piégeage de la couche de référence soit supérieure à celle de la couche antiferromagnétique 601 de piégeage de la couche d'application du champ transverse.

Dans la configuration de la figure 23, au cours du refroidissement sous champ depuis la plus haute température de blocage, on peut d'abord piéger l'aimantation de la couche 600 couplée à la couche antiferromagnétique 601 de plus haute température de blocage lors du refroidissement de $T_{B\ PtMn}$ à $T_{B\ IrMn}$. On tourne alors le champ appliqué pendant le recuit dans la direction désirée pour piéger la couche de référence couplée à la couche antiferromagnétique de plus faible température de blocage et on refroidit dans ce nouveau champ de $T_{B\ IrMn}$ à la température ambiante.

Les flèches courbées représentent le champ rayonné par la couche 600 de CoFe sur la couche de stockage 201. Les flèches droites représentent la direction du champ transverse (et donc l'aimantation) de la couche 600 de CoFe.

Une seconde façon de créer ce champ permanent est illustrée sur la figure 24. Elle consiste à intégrer au-dessus de la couche de référence 208, une couche 700 de matériau dur, par exemple de $Co_{80}Cr_{20}$ d'une épaisseur de quelques nanomètres (par exemple 5 nm) formant un aimant permanent créant un champ de polarisation transverse. La « dureté » d'une couche magnétique se définit par rapport à la valeur du champ magnétique coercitif nécessaire au renversement de l'aimantation de la couche. Telle couche magnétique sera donc réputée plus « dure » si son champ coercitif est plus fort.

La couche de matériau dur 700 peut être éloignée de la couche de référence 208 barrière tunnel 4 via l'utilisation d'une couche espaceur 701, par exemple réalisée en Ta.

L'aimantation de la couche d'application du champ transverse peut être orientée dans la direction transverse après l'étape de recuit de la structure en appliquant un champ saturant dans la direction transverse. On notera que cette couche peut aussi être mise à la base de l'empilement au lieu d'être placée en haut de l'empilement.

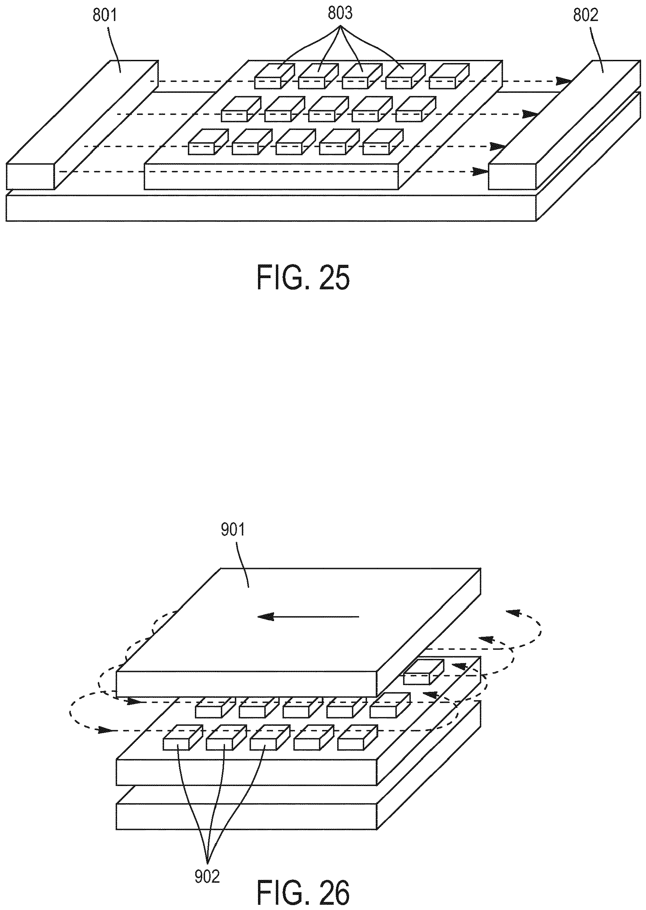

Selon un autre mode de réalisation représenté en figure 25, on peut également utiliser en tant que moyens de génération du champ transverse deux aimants permanents 801 et 802 situés de part et d'autre d'un dispositif selon l'invention ou d'un bloc avec plusieurs dispositifs selon l'invention 803 tels que des composants mémoires, memristors ou logiques, ces deux aimants permanents créant un champ transverse sur l'ensemble du bloc.

Selon un autre mode de réalisation représenté en figure 26, on peut également utiliser en tant que moyens de génération du champ de polarisation un aimant permanent 901 situé au-dessus ou au-dessous d'un ou de plusieurs points mémoire 902, memristors ou logiques, et recouvrant l'ensemble desdits points mémoire 902. Cet aimant permanent est par exemple réalisé dans un matériau dur ou d'aimantation piégée.

Naturellement, l'invention n'est pas limitée aux modes de réalisation décrits en référence aux figures et des variantes peuvent être envisagées sans sortir du cadre de l'invention telle que définie par les revendications. En particulier, les matériaux et les épaisseurs choisis pour réaliser les moyens d'application du champ transverse, les couches de référence, les couches de stockage, les espaceurs et les polariseurs perpendiculaires ne sont donnés ici qu'à titre illustratif et d'autres matériaux ou épaisseurs pourraient être utilisés.

**Revendications**

1.  Dispositif magnétique (200) comportant :

    - une première couche magnétique (201), dite couche de stockage, présentant une anisotropie uniaxiale avec un axe facile d'aimantation dans le plan de ladite couche de stockage et ayant une aimantation de direction variable possédant deux positions d'équilibre suivant ledit axe facile d'aimantation ;
    - une deuxième couche magnétique (203), dite couche de polarisation de spin d'électrons, ayant une aimantation perpendiculaire à celle de ladite couche de stockage et située hors du plan de la couche de polarisation de spin d'électrons;
    - des moyens (204) pour faire circuler dans les couches, et perpendiculairement à celles-ci, une impulsion de courant pour commuter d'une position d'équilibre de la direction d'aimantation de la couche de stockage à l'autre ;
    - des moyens (205) pour appliquer un champ magnétique, dit champ transverse, dont la direction est sensiblement parallèle au plan de ladite couche de stockage et sensiblement perpendiculaire à l'axe facile d'aimantation de la couche de stockage ;

    ledit dispositif étant **caractérisé en ce que**

    - lesdits moyens pour faire circuler une impulsion de courant et lesdits moyens pour appliquer un champ magnétique transverse sont configurés de sorte que le produit scalaire $\left(\vec{J} \times \vec{M}_{initiale}\right).\vec{H}_y$, le signe « x » désignant le produit vectoriel, soit du même signe que la composante de l'aimantation de la couche de polarisation suivant un axe allant de la couche de polarisation vers la couche de stockage, où $\vec{M}_{initiale}$ représente le vecteur d'aimantation initiale dans l'une des deux positions d'équilibre de la couche de stockage, $\vec{J}$ représente le vecteur de densité de courant pour faire commuter l'aimantation de la couche de stockage de l'état initial $\vec{M}_{initiale}$ correspondant à la position d'équilibre avant commutation vers l'état final correspondant au deuxième état d'équilibre après commutation et $\vec{H}_y$ représente le vecteur du champ transverse.
    - l'amplitude de l'impulsion de courant d'écriture et celle du champ magnétique transverse sont choisies pour commuter l'aimantation de la couche de stockage d'une position d'équilibre à une autre position d'équilibre, l'état final de l'aimantation de la couche de stockage étant contrôlé par la direction de l'impulsion de courant traversant l'empilement, indépendamment de son état initial et de la durée de l'impulsion de courant d'écriture.

2.  Dispositif selon la revendication précédente **caractérisé en ce qu'**il comporte

    - une troisième couche magnétique, dite couche de référence, ayant une aimantation de direction fixe située dans le plan de la couche de référence sensiblement selon ledit axe facile d'aimantation ;
    - une couche non magnétique, dite premier espaceur, séparant ladite couche de référence et ladite couche de stockage.

3.  Dispositif selon la revendication précédente **caractérisé en ce qu'**au moins l'une desdites couches de référence, de stockage ou de polarisation de spin d'électrons est une couche antiferromagnétique synthétique formée par deux couches ferromagnétiques et couplées antiparallèlement par une couche apte à induire un couplage antiferromagnétique entre les couches ferromagnétiques.

4.  Dispositif selon l'une des revendications 2 ou 3 **caractérisé en ce qu'**au moins l'une desdites couches de référence ou de polarisation de spin d'électrons présente une aimantation piégée par interaction avec une couche antiferromagnétique de piégeage.

5.  Dispositif selon la revendication 1 et la revendication 2 **caractérisé en ce que** la direction du champ transverse est choisie par rapport à la direction d'aimantation de ladite couche de référence et celle de ladite couche de polarisation de spin de sorte que le produit scalaire $\left(\vec{M}_{analyseurplanaire} \times \vec{P}\right).\vec{H}_y$ soit strictement positif, où $\vec{M}_{analyseurplanaire}$ est le vecteur d'aimantation de direction fixe de la couche de référence et $\vec{P}$ est le vecteur d'aimantation de la couche de polarisation de spin.

6. Dispositif selon les revendications 3 et 4, **caractérisé en ce que** lorsque la couche de stockage est une couche antiferromagnétique synthétique, la direction du champ transverse est choisie par rapport à la direction d'aimantation de ladite couche de référence et celle de ladite couche de polarisation de spin de sorte que le produit scalaire

$$\left(\vec{M}_{analyseurplanaire} \times \vec{P}\right)\vec{H}_y$$ soit strictement négatif, où $\vec{M}_{analyseurplanaire}$ est le vecteur d'aimantation de direction fixe de la couche de référence et $\vec{P}$ est le vecteur d'aimantation de la couche de polarisation de spin.

7. Dispositif selon l'une des revendications précédentes **caractérisé en ce qu'**il comporte une couche, dite second espaceur, séparant ladite couche de stockage et ladite couche de polarisation de spin d'électrons.

8. Dispositif selon la revendication précédente et l'une des revendications 2 à 5 **caractérisé en ce que** le produit de la résistance par la surface dudit premier espaceur est supérieur au produit de la résistance par la surface dudit second espaceur.

9. Dispositif selon la revendication 6 et l'une des revendications 2 à 5 **caractérisé en ce que** ledit premier espaceur est une barrière tunnel et ledit second espaceur est choisi parmi les éléments suivants :

- une barrière tunnel ;
- une barrière à chemins de courant confinés ;
- une couche métallique non magnétique.

10. Dispositif magnétique selon l'une des revendications précédentes **caractérisé en ce que** lesdits moyens pour appliquer ledit champ transverse sont formés par une couche de matériau ferromagnétique.

11. Dispositif magnétique selon l'une des revendications précédentes 1 à 9 **caractérisé en ce que** lesdits moyens pour appliquer ledit champ transverse sont formés par une couche de matériau ferromagnétique dont l'aimantation est piégée par une couche antiferromagnétique.

12. Dispositif magnétique selon l'une des revendications 1 à 9 **caractérisé en ce que** lesdits moyens pour appliquer ledit champ transverse sont formés par une ligne conductrice de génération de champ dans laquelle circule un courant.

13. Dispositif magnétique selon l'une des revendications 1 à 9 **caractérisé en ce que** lesdits moyens pour appliquer ledit champ transverse sont formés par un aimant permanent situé au-dessus ou au-dessous du dispositif magnétique.

**Patentansprüche**

1. Magnetvorrichtung (200), aufweisend:

- eine erste Magnetschicht (201), bezeichnet als Speicherschicht, aufweisend eine uniaxiale Anisotropie mit einer leichten Magnetisierungsachse in der Ebene der Speicherschicht und mit einer variabel ausgerichteten Magnetisierung mit zwei Gleichgewichtslagen gemäß der leichten Magnetisierungsachse,
- eine zweite Magnetschicht (203), bezeichnet als Elektronenspin-Polarisationsschicht, mit einer senkrechten Magnetisierung zu der der Speicherschicht und außerhalb der Ebene der Elektronenspin-Polarisationsschicht,
- Mittel (204), die veranlassen, dass in den Schichten und senkrecht zu ihnen ein Stromimpuls zirkuliert, um von einer Gleichgewichtslage der Magnetisierungsrichtung der Speicherschicht in die andere umzuschalten,
- Mittel (205), um ein Magnetfeld, bezeichnet als transversales Feld, anzulegen, dessen Richtung etwa parallel zur Ebene der Speicherschicht und etwa senkrecht zu der leichten Magnetisierungsachse der Speicherschicht ist,

wobei die Vorrichtung **dadurch gekennzeichnet ist, dass**

- die Mittel, die die Zirkulation eines Stromimpulses veranlassen und die Mittel zum Anlegen eines transversalen Magnetfelds derart konfiguriert sind, dass das Skalarprodukt $(\vec{J} \times \vec{M}_{initial}) \cdot \vec{H}_y$, wobei das Zeichen "x" das das Vektorprodukt bezeichnet, dasselbe Vorzeichen hat wie die Magnetisierungskomponente der Polarisationsschicht gemäß einer Achse von der Polarisationsschicht zu der Speicherschicht, wobei $\vec{M}_{initial}$ den Initial-Magnetisierungsvektor in einer der beiden Gleichgewichtslagen der Speicherschicht darstellt, $\vec{J}$ den Stromdichtevektor zwecks Umschaltung der Magnetisierung der Speicherschicht aus dem Initialzustand $\vec{M}_{initial}$, der der Gleichgewichtslage vor Umschaltung entspricht, in den Endzustand, der dem zweiten Gleichgewichtszustand nach Umschaltung entspricht, darstellt, und $\vec{H}_y$ den Vektor des transversalen Felds darstellt,

- die Amplitude des Stromschreibimpulses und die des transversalen Magnetfelds ausgewählt sind, um die Magnetisierung der Speicherschicht aus einer Gleichgewichtslage in eine andere Gleichgewichtslage umzuschalten, wobei der Endzustand der Magnetisierung der Speicherschicht von der Richtung des Stromimpulses kontrolliert wird, der den Stapel durchquert, unabhängig von ihrem Initialzustand und von der Dauer des Stromschreibimpulses.

2. Vorrichtung nach vorangehendem Anspruch, **dadurch gekennzeichnet, dass** sie aufweist

- eine dritte Magnetschicht, bezeichnet als Referenzschicht, mit einer Magnetisierung fester Richtung in der Ebene der Referenzschicht etwa gemäß der leichten Magnetisierungsachse,
- eine nichtmagnetische Schicht, bezeichnet als erster Spacer, der die Referenzschicht und die Speicherschicht trennt.

3. Vorrichtung nach vorangehendem Anspruch, **dadurch gekennzeichnet, dass** mindestens eine der Elektronenspin-Referenz-, Speicher- oder Polarisationsschichten eine synthetische antiferromagnetische Schicht ist, gebildet von zwei ferromagnetischen Schichten und antiparallel von einer Schicht, die imstande ist, eine antiferromagnetische Kopplung zwischen den ferromagnetischen Schichten zu induzieren, gekoppelt.

4. Vorrichtung nach einem der Ansprüche 2 oder 3, **dadurch gekennzeichnet, dass** mindestens eine der Elektronenspin-Referenz- oder Polarisationsschichten eine durch Interaktion mit einer antiferromagnetischen Fixierschicht fixierte Magnetisierung aufweist.

5. Vorrichtung nach Anspruch 1 und Anspruch 2, **dadurch gekennzeichnet, dass** die Richtung des transversalen Felds in Bezug auf die Magnetisierungsrichtung der Referenzschicht und der der Spin-Polarisationsschicht derart gewählt ist, dass das Skalarprodukt $(\vec{M}_{Planaranalysator} \times \vec{P}) \cdot \vec{H}_y$ nur positiv ist, wobei $\vec{M}_{Planaranalysator}$ der Magnetisierungsvektor fester Richtung der Referenzschicht ist und $\vec{P}$ der Magnetisierungsvektor der Spin-Polarisationsschicht ist.

6. Vorrichtung nach den Ansprüchen 3 und 4, **dadurch gekennzeichnet, dass**, wenn die Speicherschicht eine synthetische antiferromagnetische Schicht ist, die Richtung des transversalen Felds in Bezug auf die Magnetisierungsrichtung der Referenzschicht und der der Spin-Polarisationsschicht derart gewählt ist, dass das Skalarprodukt $(\vec{M}_{Planaranalysator} \times \vec{P}) \cdot \vec{H}_y$ nur negativ ist, wobei $\vec{M}_{Planaranalysator}$ der Magnetisierungsvektor fester Richtung der Referenzschicht ist und $\vec{P}$ der Magnetisierungsvektor der Spin-Polarisationsschicht ist.

7. Vorrichtung nach einem der vorangehenden Ansprüche, **dadurch gekennzeichnet, dass** sie eine Schicht, bezeichnet als zweiter Spacer, aufweist, der die Speicherschicht und die Elektronenspin-Polarisationsschicht trennt.

8. Vorrichtung nach vorangehendem Anspruch und einem der Ansprüche 2 bis 5, **dadurch gekennzeichnet, dass** Produkt des Widerstands durch die Oberfläche des erster Spacers größer als das Produkt des Widerstands durch die Oberfläche des zweiten Spacers ist.

9. Vorrichtung nach Anspruch 6 und einem der Ansprüche 2 bis 5, **dadurch gekennzeichnet, dass** der erste Spacer eine Tunnelbarriere ist und der zweite Spacer aus den folgenden Elementen ausgewählt ist:

- einer Tunnelbarriere,
- einer Barriere mit beschränkten Strompfaden,
- einer nichtmagnetischen Metallschicht.

**10.** Magnetvorrichtung nach einem der vorangehenden Ansprüche, **dadurch gekennzeichnet, dass** die Mittel zum Anlegen des transversalen Felds von einer Schicht aus ferromagnetischem Material gebildet sind.

**11.** Magnetvorrichtung nach einem der vorangehenden Ansprüche 1 bis 9, **dadurch gekennzeichnet, dass** die Mittel zum Anlegen des transversalen Felds von einer Schicht aus ferromagnetischem Material gebildet sind, dessen Magnetisierung durch eine antiferromagnetische Schicht fixiert ist.

**12.** Magnetvorrichtung nach einem der Ansprüche 1 bis 9, **dadurch gekennzeichnet, dass** die Mittel zum Anlegen des transversalen Felds von einer leitenden Felderzeugungsleitung gebildet sind, in der ein Strom fließt.

**13.** Magnetvorrichtung nach einem der Ansprüche 1 bis 9, **dadurch gekennzeichnet, dass** die Mittel zum Anlegen des transversalen Felds von einem Dauermagneten gebildet sind, der sich über oder unter der Magnetvorrichtung befindet.

## Claims

**1.** Magnetic device (200) comprising:

- a first magnetic layer (201), known as storage layer, having a uniaxial anisotropy with an easy magnetisation axis in the plane of said storage layer and having a magnetisation of variable direction having two positions of equilibrium along said easy magnetisation axis;
- a second magnetic layer (203), known as electron spin polarisation layer, having a magnetisation perpendicular to that of said storage layer and situated out of plane of the electron spin polarisation layer;
- means (204) for making circulate in the layers, and perpendicularly thereto, a current pulse to switch from one position of equilibrium of the direction of magnetisation of the storage layer to the other;
- means (205) for applying a magnetic field, known as transverse field, the direction of which is substantially parallel to the plane of said storage layer and substantially perpendicular to the easy magnetisation axis of the storage layer;

said device being **characterised in that**

- said means for making a current pulse circulate and said means for applying a transverse magnetic field are configured such that the scalar product $\left( \vec{J} \times \vec{M}_{initial} \right).\vec{H}_y$ , the sign "x" designating the vectorial product, is of the same sign as the component of the magnetisation of the polarisation layer along an axis going from the polarisation layer to the storage layer, where $\vec{M}_{initial}$ represents the initial magnetisation vector in one of the two positions of equilibrium of the storage layer, $\vec{J}$ represents the current density vector to switch the magnetisation of the storage layer from the initial state $\vec{M}_{initial}$ corresponding to the position of equilibrium before switching to the final state corresponding to the second state of equilibrium after switching and $\vec{H}_y$ represents the vector of the transverse field,
- the amplitude of the writing current pulse and that of the transverse magnetic field are chosen to switch the magnetisation of the storage layer from one position of equilibrium to another position of equilibrium, the final state of the magnetisation of the storage layer being controlled by the direction of the current pulse passing through the stack, independently of its initial state and the duration of the writing current pulse.

**2.** Device according to the preceding claim **characterised in that** it comprises:

- a third magnetic layer, known as reference layer, having a magnetisation of fixed direction situated in the plane of the reference layer substantially along said easy magnetisation axis;
- a non-magnetic layer, known as first spacer, separating said reference layer and said storage layer.

**3.** Device according to the preceding claim **characterised in that** at least one of said reference, storage or electron spin polarisation layers is a synthetic antiferromagnetic layer formed of two layers of fixed magnetisation and coupled in an antiparallel manner by a layer able to induce antiferromagnetic coupling between the ferromagnetic layers.

**4.** Device according to one of claims 2 or 3 **characterised in that** at least one of said reference or electron spin polarisation layers has a magnetisation pinned by interaction with an antiferromagnetic pinning layer.

**5.** Device according to claim 1 and claim 2 **characterised in that** the direction of the transverse field is chosen with respect to the direction of magnetisation of said reference layer and that of said spin polarisation layer such that the scalar product $\left(\vec{M}_{planaranalyser} \times \vec{P}\right).\vec{H}_y$ is strictly positive, where $\vec{M}_{planaranalyser}$ is the magnetisation vector of fixed direction of the reference layer and P is the magnetisation vector of the spin polarisation layer.

**6.** Device according to claims 3 and 4, **characterised in that** when the storage layer is a synthetic antiferromagnetic layer, the direction of the transverse field is chosen with respect to the direction of magnetisation of said reference layer and that of said spin polarisation layer such that the scalar product $\left(\vec{M}_{planaranalyser} \times \vec{P}\right).\vec{H}_y$ is strictly negative, where $\vec{M}_{planaranalyser}$ is the magnetisation vector of fixed direction of the reference layer and $\vec{P}$ is the magnetisation vector of the spin polarisation layer.

**7.** Device according to one of the preceding claims **characterised in that** it comprises a layer, known as second spacer, separating said storage layer and said electron spin polarisation layer.

**8.** Device according to the preceding claim and one of claims 2 to 5 **characterised in that** the product of the resistance times the surface of said first spacer is greater than the product of the resistance times the surface of said second spacer.

**9.** Device according to claim 6 and one of claims 2 to 5 **characterised in that** said first spacer is a tunnel barrier and said second spacer is chosen from the following elements:

 - a tunnel barrier;
 - a confined current path barrier;
 - a non-magnetic metal layer.

**10.** Magnetic device according to one of the preceding claims **characterised in that** said means for applying said transverse field are formed by a layer of ferromagnetic material.

**11.** Magnetic device according to one of the preceding claims 1 to 9 **characterised in that** said means for applying said transverse field are formed by a layer of ferromagnetic material the magnetisation of which is pinned by an antiferromagnetic layer.

**12.** Magnetic device according to one of claims 1 to 9 **characterised in that** said means for applying said transverse field are formed by a field generating conducting line in which a current circulates.

**13.** Magnetic device according to one of claims 1 to 9 **characterised in that** said means for applying said transverse field are formed by a permanent magnet situated above or below the magnetic stack.

FIG. 1

EP 3 026 721 B1

FIG. 2

FIG. 3

FIG. 4

FIG. 5

FIG. 6

100

106    107

Hy    — 105

101

102

Cu

FIG. 7

M_sto

z

o    y

x

103

104

100

106    107    z

101

102

Cu    M_sto

z

o    y

x

FIG. 8

Hy = champ transverse

103

111

electrons    J

104

100

106    107

z

z

o    y
x

101    $M_{sto}$

102    Cu

Hy = champ transverse

103

111

electrons    J

104

**FIG. 9**

200

210

208

z

z

209    Barrière tunnel

207    o    y
x

206
201    $M_{sto}$

202    Cu

205
Hy = champ transverse

203

211

electrons    J

204

**FIG. 10**

FIG. 11a

FIG. 11b

Hy = 0 kA/m

FIG. 12a

FIG. 12b

Hy = 5 kA/m

FIG. 12c

Hy = 5 kA/m

FIG. 13

FIG. 14

FIG. 15

Hy = 4800.00 A/m
J = 1.541e+011 A/m2

FIG. 16

Hy = 4800.00 A/m
J = 2.502e+011 A/m2

FIG. 17

Hy = 4800.00 A/m
J = 3.078e+011 A/m2

300

308 — Couche de protection et d'arrêt de CMP

Couche de référence piégée

307 — IrMn 6.0nm

314 — CoFe 2.0nm ⎫
313 — Ru 0.8nm ⎬ 301
312 — CoFeB 2.0nm ⎭

302 — MgO 1.1nm

Couche de stockage
303

311 — CoFeB 1.5nm
310 — Ta 0.3nm
CoFe 1nm
309 — Cu 3nm

304 — (Co 0.4nm/Cu0.2nm)2/Co0.6nm

Polariseur perpendiculaire
305 — Multicouches (Co 0.4nm/Pt0.6nm)$_6$

306 — Buffer Ta/Ru/Ta

FIG. 18

400

z

o

x          y

308 ——— Couche de protection et d'arrêt de CMP

307 ——— IrMn 6.0nm

Couche de
référence     314 ——— CoFe 2.0nm        } 301
piégée        313 ——— Ru 0.8nm
              312 ——— CoFeB 2.0nm

302 ——— MgO 1.1nm

Couche de stockage  412 ——— CoFeB 1.5nm  } 409
Synthétique         413 ——— Ta 0.3nm
antiferromagnétique 414 ——— CoFe 1nm
                    410 ——— Ru 0.8nm
403                 411 ——— CoFe 2.0nm

304 ——— Cu3nm

Polariseur                 } (Co 0.4nm/Cu0.2nm)2/Co0.6nm
perpendiculaire
305 ———        Multicouches (Co 0.4nm/Pt0.6nm)$_6$

306 ——— Buffer Ta/Ru/Ta

FIG. 19

FIG. 20

FIG. 21

FIG. 22b

FIG. 22a

602
601
600
200
208
209
201
202
203

Cu 20nm
PtMn 20nm
CoFe 6nm

Hy

Oxyde

Copper

FIG. 23

200
700
701
208
209
202
203

Couche de bias transverse en
matériau dur ex: $Co_{80}Cr_{20}$

Espaceur

Couche de référence piégée

Oxyde

Couche de stockage

Cu

Polariseur perpendiculaire

FIG. 24

801     803     802

FIG. 25

901

902     FIG. 26

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2817998
- US 20080197431 A1
- US 20120294078 A1

**Littérature non-brevet citée dans la description**

- **VAYSSET et al.** Improved coherence of ultrafast spin-transfer-driven precessional switching with synthetic antiferromagnet perpendicular polarizer. *Applied Physics Letters,* 2011, vol. 98, 242511
- **D. HOUSSAMEDDINE et al.** Spintorque oscillator using a perpendicular polarizer and a planar free layer. *Nature Materials,* 2007, vol. 6, 447
- **KJ LEE et al.** Analytical investigation of spin-transfer dynamics using a perpendicular-to-plane polarizer. *APPLIED PHYSICS LETTERS,* 2005, vol. 86, 022505